(19) Europäisches Patentamt
European Patent Office
Office européen des brevets

(11) **EP 2 000 560 B1**

(12) **EUROPEAN PATENT SPECIFICATION**

(45) Date of publication and mention
of the grant of the patent:
**02.10.2013 Bulletin 2013/40**

(51) Int Cl.:
*C23C 16/26* [(2006.01)]    *C23C 14/06* [(2006.01)]

(21) Application number: **08016391.8**

(22) Date of filing: **09.02.2000**

(54) **Hard coating and coated member**

Hartbeschichtung und beschichtetes Bauteil

Revêtement dur et élément revêtu

(84) Designated Contracting States:
**DE FR GB IT**

(30) Priority: **08.07.1999 JP 19509999**
**26.10.1999 JP 30428499**
**24.12.1999 JP 36784499**

(43) Date of publication of application:
**10.12.2008 Bulletin 2008/50**

(62) Document number(s) of the earlier application(s) in
accordance with Art. 76 EPC:
**00301009.7 / 1 067 211**

(73) Proprietor: **SUMITOMO ELECTRIC INDUSTRIES,
LTD**
**Osaka-shi, Osaka (JP)**

(72) Inventors:
• **Irie, Miki**
**Itami-shi**
**Hyogo (JP)**
• **Oda, Kazuhiko**
**Itami-shi**
**Hyogo (JP)**

(74) Representative: **Cross, Rupert Edward Blount**
**Boult Wade Tennant**
**Verulam Gardens**
**70 Gray's Inn Road**
**London WC1X 8BT (GB)**

(56) References cited:
**EP-A- 0 379 220**    **EP-A- 0 435 312**
**EP-A- 0 905 420**    **US-A- 4 932 331**
**US-A- 5 205 188**

• **RONKAINEN H ET AL: "Friction and wear
properties in dry, water- and oil-lubricated DLC
against alumina and DLC against steel contacts"
WEAR, vol. 222, no. 2, November 1998 (1998-11),
pages 120-128, XP002501461 ELSEVIER [CH]
ISSN: 0043-1648**
• **BULL S J ET AL: "HIGH-PERFORMANCE
DIAMOND AND DIAMOND-LIKE COATINGS"
JOM, vol. 47, no. 4, 1 April 1995 (1995-04-01),
pages 16-19, XP000500980 MINERALS, METALS
AND MATERIALS SOCIETY, WARRENDALE [US]
ISSN: 1047-4838**
• **LIFSHITZ Y: "HYDROGEN-FREE AMORPHOUS
CARBON FILMS: CORRELATION BETWEEN
GROWTH CONDITIONS AND PROPERTIES"
DIAMOND AND RELATED MATERIALS, vol. 5, no.
3/05, 1 April 1996 (1996-04-01), pages 388-400,
XP000627537 ELSEVIER SCIENCE
PUBLISHERS, AMSTERDAM [NL] ISSN:
0925-9635**
• **HOLMBERG K ET AL: "TRIBOLOGICAL
CHARACTERISTICS OF DIAMOND-LIKE
CARBON COATINGS" VTT SYMPOSIUM [FI],
TECHNICAL RESEARCH CENTRE OF FINLAND,
1994, pages 24-38, XP000570636 ISSN: 0357-9387**

**Description**

The present invention relates to a hard coating mainly consisting of carbon and a coated member. More specifically, the present invention relates to a hard coating and a coated member used in the presence of a lubricant in industry and at homes having improved wear resistance, low coefficient of friction, less attacking nature (amount of wear of the counterpart is small), improved corrosion resistance and improved function of surface protection.

Conventionally, parts used at a sliding portion of an automobile engines, a fuel pump and various machines have been subjected to surface processing to improve sliding characteristic. The sliding characteristic is determined by wear resistance, seizure resistance and the coefficient of friction. In order to improve these characteristics, attempts have been made to improve quality of the surface of a member or to coat the surface of a member by nitriding, plating, thermal spraying, or physical deposition. Surface coating by physical deposition, among others, has been known to exhibit superior sliding characteristic (for example, see Japanese Patent Publication No. 1- 52471, Japanese Patent Laying- Open No. 62- 120471) .

Specifically, a hard carbon film referred to as diamond like carbon (DLC), i- C or amorphous carbon has been known as a material which improves sliding characteristic of a part when provided on the surface of the part. DLC mainly consist of carbon and sometimes contains hydrogen, in which carbon atoms have $SP^2$ bond or $SP^3$ bond, while it is as a whole an amorphous material. Because of the film characteristic and surface smoothness, DLC has low coefficient of friction and high wear resistance, and has been widely used.

Most of the parts used at the sliding portion of internal combustion engine and various machines are used in the presence of a lubricant oil. Recently, in view of environmental influence, decrease in wear loss  generated by these parts has been strongly desired. When viewed from the point of material, in order to meet the demand, it is necessary to improve wear resistance and to decrease the coefficient of friction in the presence of a lubricant oil.

The friction force in the presence of a lubricant oil is determined by the sum of a friction force generated by a solid-solid contact and a shear force necessary to separate lubricant oil molecules, as represented by the following equation.

$$F = A \{\alpha Sm + (1 - \alpha) S\ell\} \qquad \qquad ... (1)$$

F: friction force, A: load, $\alpha$: ratio of solid-solid contact at a sliding surface, Sm: coefficient of friction of solid-solid contact, $S\ell$: coefficient of friction of lubricant oil molecule-lubricant oil molecule.

Therefore, in order to decrease the coefficient of friction in the presence of a lubricant oil, possible approaches are as follows:

(1) to decrease solid-solid coefficient of friction Sm; and
(2) to decrease the ratio $\alpha$ of solid-solid contact (to increase ratio of lubrication by the lubricant oil).

For the approach (1), at present, it is considered effective to improve quality or coat the surface of a part by nitriding, plating, thermal spraying, CVD or PVD, and such attempts have exhibited significant effects as compared with the conventional parts.

For the approach (2), an attempt to reduce the ratio of solid-solid contact by reducing surface roughness of the surface of the part by super polishing and an attempt to increase the ratio of lubrication by the lubricant oil by forming appropriate dents or recesses on the surface of the part to facilitate formation of an oil film and to increase the thickness of the oil film have been made.

Now, DLC is also used as a protective layer mainly of a magnetic recording medium. In this field, the structure of the DLC coating is analyzed by Raman scattering spectroscopy, EELS (Electronic Energy Loss Spectrum) or infrared spectroscopy. Particularly, in order to further improve durability while maintaining the coefficient of friction or further to decrease the coefficient of friction, a proposal has been made in which the  profile of Raman spectrum is defined by Raman scattering spectroscopy, as described, for example, in the following articles.

Definition of peak intensity ratios appearing around 1550cm$^{-1}$ and around 1340cm$^{-1}$: Japanese Patent Laying-Open Nos. 2-29919, 3-37109, 5-151560, 5-174368 and 5-325175.

Definition of area intensity ratio: Japanese Patent Laying-Open Nos. 6-111287, 6-267063, 6-349055, 7-85465, 7-192254, 9-91686 and 10-91935.

Definition of fluorescent intensity ratio of the peaks: Japanese Patent Laying-Open Nos. 8-329450, 9-153213, 11-25441, 11-86275 and 10-49856.

An example in which the hard carbon film is applied in the presence of a lubricant oil, however, has been not known. Further, conditions of the coating to be used in the presence of a lubricant oil have not been optimized. Though there are a few examples defining the hardness of DLC (Japanese Patent Laying-Open Nos. 1-226711, 5-117087, 9-40494 and 5-117856), these examples are all directed to improved adhesion between DLC and the substrate, and not directed to optimization of the conditions of the coating in the presence of a lubricant oil.

As to the approach of "decreasing solid-solid coefficient of friction Sm", even a material having both good wear resistance and low coefficient of friction such as DLC has the coefficient of friction of about 0.1, and creation of a material which enables lower coefficient of friction may be difficult. Therefore, it is difficult to further decrease the coefficient of friction in the presence of a lubricant oil simply by "decrease of solid-solid coefficient of friction Sm."

As to the approach of "decreasing the ratio $\alpha$ of solid-solid contact", the condition of use of the part would be more severe and wear of the part is expected in case where the part should possibly be slid with insufficient lubricant oil. Further, super polishing or introduction of dents will lose the effect when the surface shape would be changed by wear.

The articles related to DLC as the protective layer of the magnetic recording medium are all related to hard carbon films formed by CVD or sputtering. Further, such hard carbon films contain hydrogen of about 20 at.% or more. Further, because of the function as a protective layer of the magnetic recording medium, the film thickness is very thin, generally smaller than 0.1 μm.

By contrast, when the parts used for sliding portions of automobile engines, fuel pumps and various machines are considered, the field of use requires higher durability than for the magnetic recording medium. Though proposals have been made in Japanese Patent Laying-Open Nos. 5-296248 and 5-186287, for example, lower coefficient of friction and higher wear resistance are still desirable.

WEAR ZZZ (1998) 120-128 relates to friction and wear properties in dry, water-and-oil lubricated DLC against alumina and DLC against steel contacts. EP 0 905 420 A2 relates to a piston ring.

Therefore, an object of the present invention is to provide a hard coating and a coated member having improved wear resistance and a lower coefficient of friction in the presence of lubricant oil while maintaining high wear resistance, high seizure resistance and small attacking property.

The above described object of the present invention can be attained by the hard coating used in the presence of a lubricant and includes a layer mainly consisting of carbon. The present invention provides a coated member according to claim 1 of the claims appended hereto. The features of the coating will be described in the following.

(Lubricant)

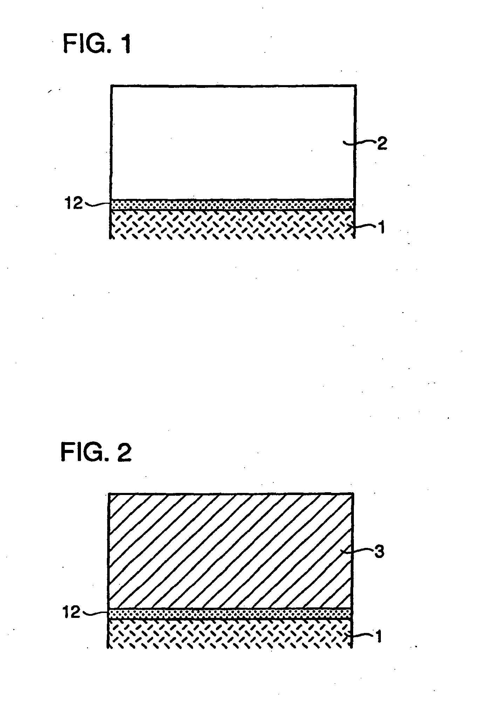

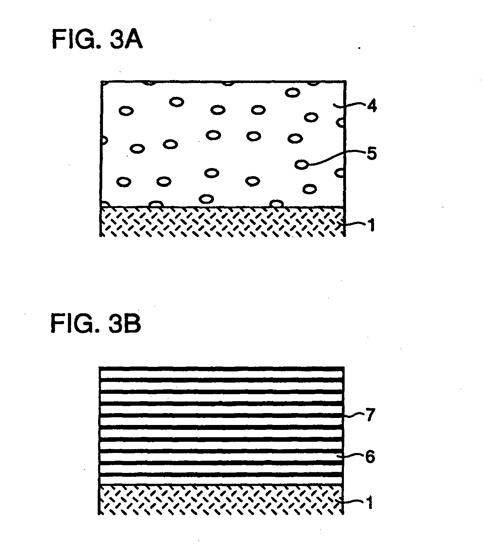

The hard coating of the present invention, though it also exhibits its effect in air, exhibits the significant effect of decreasing the coefficient friction especially in the presence of a lubricant. Preferable lubricant may be selected from the group consisting of engine oil, light oil, gasoline, gear oil, turbine oil, spindle oil, machine oil, mobile oil, aircraft lubricant oil and grease. Particularly, the lubricant in the coating according to Figs.2, 3A and 3B preferably includes an aromatic compound mixed in any of the lubricant oils listed above. The aromatic compound refers to a carbocylic compound having a benzene nucleus, and generally to organic compounds including aromatic hydrocarbon such as benzene, napthalene and anthracene and derivatives thereof. As to the content of the aromatic compound, it is preferred to that ratio of carbon forming the aromatic cycle is at least 5 wt% of the total amount of carbon in the lubricant oil. If the ratio is smaller than 5%, the effect of improved lubricancy is insufficient.

The reason why DLC decreases the coefficient of friction and improves wear resistance in the presence of lubricant oil containing an aromatic compound as compared with the lubricant oil not containing the aromatic compound is not clear. It may be the case that the ratio of lubcrication is increased in the lubcricant oil. The lubcricant oil molecules are adsorbed by the van der Waals force at the surface of a material in the sliding state. If the adsorbing force is high, a strong oil film is formed and the thickness of the oil film increases, resulting in increased ratio of lubrication in the lubricant oil. As the aromatic compound has high adsorbing force with the DLC surface, a strong oil film tends to be formed, so that the distance between friction surfaces is increased, whereby the ratio of lubcrication in the presence of the lubcricant oil is increased. As the thickness of the oil film of the lubcricant oil increases, the ratio ($\alpha$) of solid-solid contact at a sliding surface decreases and the area of solid-solid contact reduces. Therefore, the coefficient of friction decreases and the amount of wear at the time of sliding is reduced as a result.

(Composition and Structure of Hard Coating)

A typical example of the layer mainly consisting of carbon is DLC. Here, DLC refers both to the one substantially consisting of carbon only as well as and the one substantially consisting of carbon and hydrogen only. "Substantially consisting of carbon only" means that the coating does not contain any element except for elements as impurities unavoidably existing in the process of formation It is often the case for hard coatings that DLC contain hydrogen, which exists in the reaction atmosphere at the time of film formation. The hydrogen content of the hard coating substantially consisting of carbon only in the present invention is at most 5 at.% and more preferably, at most 1 at.%.

The hard coating having low hydrogen content can be implemented by forming the film in an atmosphere not containing hydrogen atoms. When the film is formed in an atmosphere containing hydrogen atoms, it is preferred that a gas having lower hydrogen content than methane, such as acetylene and benzene is used.

As to the structure of the coating, it is preferred that a coating 2 formed on a substrate 1 consists only of DLC as shown in Fig. 1, for example. The DLC coating, however, may be a composite coating with other compound. The compound to form the composite structure may be a compound containing at least one selected from the elements of IVa, Va and VIa groups of the periodic table, iron group metal, Al and Si, as well a carbide, a nitride and a nitrided carbide of these elements. The composite structure may be provided in the following manner.

① DLC forms a compound layer 3 with other element (Fig. 2). In this example, the other element and DLC are mixed in atomic levels and bonded. Though mixed existence of DLC and the other element can be confirmed by elemental analysis, a peak of XRD (X-ray diffraction) is not observed.

② In a coating layer 4 consisting of DLC only, particles 5 of the other compound are composed (Fig. 3A). That the other compound particles are composed refers to a state in which a definite stacked structure is not observed by a transmission electron microscope and a diffraction peak of the other compound is observed by XRD. The grain diameter of the other compound can be calculated by a half value width of XRD. It is preferred that the grain diameter of the other compound is in the range of 0.001 to 0.5 $\mu$m. In a test which will be described later, any compound of which grain diameter is smaller than 0.001 $\mu$m was not observed. When the grain diameter exceeds 0.5 $\mu$m, the influence of tribological characteristic of the other compound appears, abruptly increasing the coefficient of friction.

③ A coating layer 6 consisting of DLC only and the layer 7 of other compound are stacked alternately (Fig. 3B). In this example, definite stacked structure is observed by a transmission electron microscope. It is preferred that each layer of the other compound has the thickness of 0.0005 to 0.6 $\mu$m. The thickness of each layer is calculated in the following manner. First, the growth rate of each of the coating layers formed of DLC only and the coating layer formed of the other compound is given by experiment. The thickness of each layer is calculated from the time of forming one layer. The limit layer thickness at which the stacked structure could be observed was studied by the transmission electron microscope, and the stacked structure was not observed when the layer thickness was smaller than 0.0005 $\mu$m. When the thickness exceeded 0.6 $\mu$m, the coefficient of friction increased. As compared with the coating of DLC only, the other compound generally has high coefficient of friction, and therefore when the thickness increases, the influence of the friction wear characteristic of the other compound appears, resulting in abrupt increase in the coefficient of friction. Therefore, it is suitable that the outermost surface of the coating of the stacked structure has the layer consisting of DLC only.

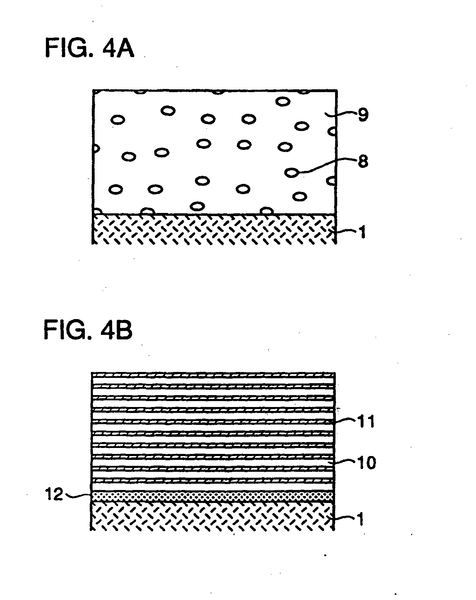

A composite structure including particles or a stacked structure may be provided by appropriately combining the "the portion (layer) consisting of DLC only", "the portion (layer) where DLC forms a compound with the other element", "the portion (layer) where particles of the other compound are composed in DLC" and "the portion (layer) of the other compound". More specifically, as shown in Fig. 4A, the coating as a whole may be provided as a composite structure including particles, which includes particle portions 8 and remaining portion 9, with each of the particle portions 8 and the remaining portion 9 formed by "the portion consisting of DLC only", "the portion where DLC forms a compound with the other element", "the portion in which particles of the other compound is composed/complexed in DLC" or "the portion of the other compound." Alternatively, as shown in Fig. 4B, the coating as a whole may be provided as a stacked structure including first layer 10 and second layer 11, with each of the first and second layers 10 and 11 being formed by "the layer consisting of DLC only", "the layer where DLC forms a compound with the other element", "the layer in which particles of the other compound is composed in DLC" or "the layer of the other compound." In "① the composite structure in which DLC forms a compound layer 3 with the other element" and "③ stacked structure", "the other compound" may be amorphous.

(Hardness of Coating)

The hard coating has Knoop hardness (Hk) of at least 1800 kg/mm$^2$ and at most 8000 kg/mm$^2$. More specifically, it is preferred that the coating has Knoop hardness of at least 2000 kg/mm$^2$ and at most 6000 kg/mm$^2$.

The hardness is measured by the indentation fracture method. A Knoop indentator formed of diamond is used, the load is 50g and the time of applying load is 10 seconds. An average value of ten measurement points is taken. When the coating surface is rough and it is difficult to confirm the shape of the dent or trace, buffing is performed using diamond paste of #8000, so as to enable observation of the shape of the dent or trace.

The reason why increased hardness decreases the coefficient of friction is not clear. One possible reason is as follows. Generally, the friction force is in proportion to an actual contact area and the load. When solid bodies are in contact with each other, not the macroscopic contact surface as a whole is in contact but microscopic protrusions such as surface roughness or ridges are in contact. The area of such contact is called the actual contact area. When the actual contact area increases, the friction force increases and hence the coefficient of friction attains higher. The actual contact surface which is the protruded portion exceeds the elastic limit as the load increases, and starts plastic deformation, so that the actual contact area increases. Here, as the surface hardness increases, elasticity and elastic limit of the material also increase, and therefore the mount of deformation reduces if the load is the same, and the actual contact area reduces. More specifically, the increased surface, hardness decreases the actual contact area, and as a result, reduces the friction force.

(Surface Roughness of Coating)

As to the surface roughness of the hard coating, in a reference example it is desirable that a central line average roughness Ra is at least 0.005 $\mu$m and at most 0.2 $\mu$m.

In the present invention the hard coating has a central line average surface roughness Ra of at least 0.005 $\mu$m and at most 0.086 $\mu$m.

When the surface roughness of the hard coating is within the above described range, the coefficient of friction in the presence of lubricant oil can be reduced. The actual contact area mentioned above increases when there are large number of surface protrusions, that is, when Ra is large. Therefore, when the film has both small Ra (of at most 0.2$\mu$m) and high Knoop hardness, the coefficient of friction in the presence of the lubricant oil would be lower than that of the coating which simply has high Knoop hardness (of at least 1800 kg/mm$^2$ and at most 8000 kg/mm$^2$). Though lower surface roughness is preferred, it is technically difficult to form a coating of which Ra is smaller than 0.005 $\mu$m. Therefore, in order to attain the lower coefficient of friction, it is desirable that Ra is at least 0.005 $\mu$m and at most 0.2 $\mu$m. The surface roughness Ra may be measured in accordance with the method defined by JIS B0601. More specifically, the measurement distance is 2.5 mm, the speed of measurement is 0.3 mm/s, Cut-off value is 0.8 mm, and an average value of eight measurement points is taken.

Among the factors determining the surface roughness of the hard coating, the most important is the surface roughness of the substrate on which the coating is formed. Therefore, before forming the coating, the surface of the substrate is lapped by abrasive materials or abrasive grains to reduce Ra. The surface roughness Ra of about 0.2 $\mu$m can be attained by grinding process. As to the method of forming the coating, a coating with considerably low surface roughness can be formed by RF excited plasma CVD, ion beam deposition or sputtering. When vacuum are discharge deposition is utilized, however, lapping of the coating by abrasive materials or abrasive grains is effective after film formation to attain the surface roughness of 0.02 $\mu$m or lower.

It is required that both conditions of the hardness and the surface roughness are satisfied. Particularly, a coating which satisfies the condition that a numerical value A, where A= Ra ($\mu$m) $\times$ Hk (kg/mm$^2$) is at most 500 (reference example) is desirable to maintain the low attacking characteristic. When the coating has high hardness, attacking characteristic increases (the amount of wear of the counterpart increases). The attacking characteristic also increases when the surface roughness increases. When the numerical value A is at most 500, however, attacking characteristic can be suppressed. Namely, even when the hardness is high, attacking characteristic can be suppressed if the surface roughness is decreased, and even when the surface is rough, the attacking characteristic can be suppressed if the hardness is decreased. In the present invention the value A should be at most 300 so as to suppress the attacking characteristic effectively.

(Spectral Profile of the Coating)

It is preferred that the hard coating has a peak at a wave number of at least 500 and at most 1000 cm$^{-1}$ in Raman spectrum.

The Raman spectrum is obtained by Raman scattering spectroscopy, using an argon ion laser having the wavelength of 514.5 nm. More specifically, from the obtained waveforms of the spectrum, background is removed, peak waveforms are separated by utilizing Gaussian function, and each peak is optimized by the non-linear least square method.

In the hard coating in accordance with the present invention, peak waveforms are observed at three portions in total, that is, between 500 to 1000 cm$^{-1}$, around 1340 cm$^{-1}$ and around 1560 cm$^{-1}$. In the conventional hard coating formed by CVD, the peak between 500 to 1000 cm$^{-1}$ is not observed. The coating structure having a peak between 500 to 1000 cm$^{-1}$ realizes further reduced coefficient of friction.

Further, when the intensity ratio (I 600/I 1340) between the peak intensity (I 600) existing in the range of 500 to 1000 cm$^{-1}$ of the wave number and the peak intensity (I 1340) existing around 1340 cm$^{-1}$ is in the range of 0.02 to 2.5, both the low coefficient of friction and the high wear resistance can be attained.

The reason for this may be that the amount of SP$^3$ bond is increased, decreasing the coefficient of friction. Though peak intensity (height) has been considered, the intensity ratio of peak integration is also concerned. The intensity ratio of peak integration (S600/S1340) should desirably be 0.01 to 2.5. When the intensity ratio of peak integration is smaller than 0.01, the coefficient of friction and the wear resistance are comparable to those of the conventional hard coating. In the embodiment of the present invention, which will be described later, it was impossible to form a coating having the peak intensity ratio of 2.5 or higher.

It is preferred that these hard coatings consists substantially of carbon only. In a hard coating substantially consisting of carbon only, the peak is observed between 500 to 1000 cm$^{-1}$.

In a hard coating substantially consisting of carbon only, when the ratio (S1340/SS1560) between the peak integration intensity (S1560) around 1560 cm$^{-1}$ and the peak integration intensity (S1340) around 1340 cm$^{-1}$ of the Raman spectrum is 0.3 to 3, low coefficient of friction and high wear resistance are exhibited. Conventionally proposed hard coatings are mainly hard coatings containing hydrogen, and hence, film composition is different from the hard coating in accordance with the present invention.

Further, in addition to the peak integration intensity, the peak intensity (height) ratio (I 1340/I 1560) is also concerned. When the ratio is in the range of 0.1 to 1.2, the low coefficient of friction and the high wear resistance are exhibited. The ratio of the peak intensity around 1560 cm$^{-1}$ and the peak intensity around 1340 cm$^{-1}$ is also referred to as SP$^2$/SP$^3$ ratio, which represents the amount of existence of the bonding states (SP$^2$, SP$^3$) of carbon in the coating. Though the peak intensity ratio does not directly represent the content of SP$^2$, relative order of contents can be determined. It was found that the coefficient of friction further decreases when the peak intensity around 1560 cm$^{-1}$ is higher. More specifically, the coefficient of friction is decreased and the wear resistance is improved when SP$^3$ bonding is strong. When S1340/S1560 exceeds 3 and when I 1340/I 1560 exceeded 1.2, that is, when SP$^3$ bond is weak, both the coefficient of friction and the wear resistance were comparable to those of the conventional hard coating. When S1340/S1560 was smaller than 0.3 and I 1340/I 1560 was smaller than 0.1, SP$^3$ bonding was too high to attain sufficient adhesion with the coating, and the coating could not be practically used.

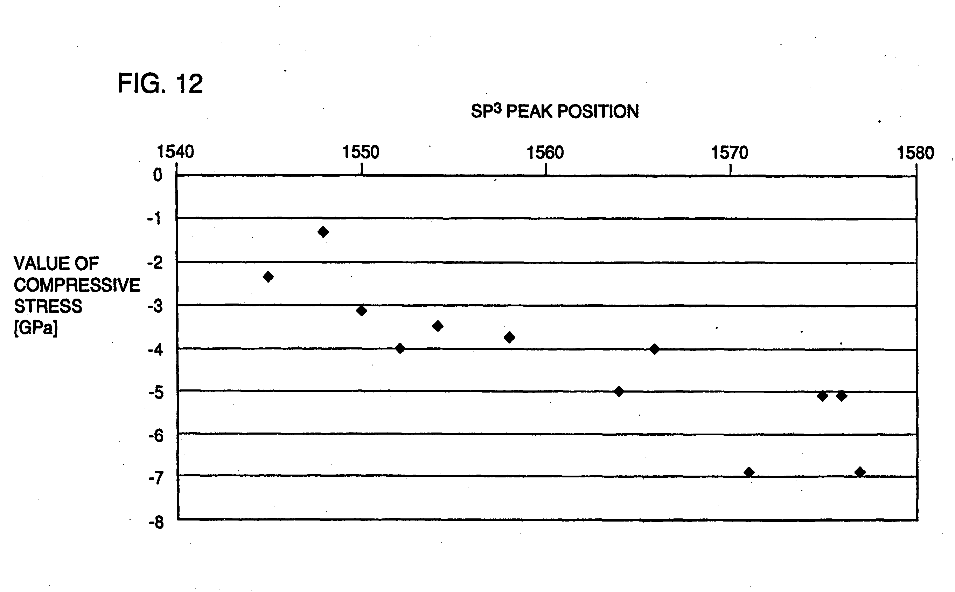

When the coating substantially consist of carbon only and "the peak around 1560 cm$^{-1}$" of Raman spectrum exists between 1560 cm$^{-1}$ to 1580 cm$^{-1}$ both the low coefficient of friction and the high wear resistance can be attained. The peak position of Raman spectrum is influenced by a residual stress of the coating. Generally, when the residual stress is compressive stress, the Raman peak shifts to the side of higher wave number and when the residual stress is tensile stress, the peak shifts to the side of lower wave number. It was found that the lower coefficient of friction and higher wear resistance can be exhibited when the residual stress of the hard coating is high in the compressive stress (that is, when the peak is on the side of higher wave number). The compressive stress calculated in terms of the amount of variation in warp (cantilever method) before and after coating film formation of the substrate was at least -4GPa and at most -10GPa. The value of compressive stress and the peak position of Raman peak around 1560 cm$^{-1}$ exhibited approximately proportional relation, as can be seen from the graph of Fig. 12.

The hard coating having all the features described above according to Raman scattering spectroscopy exhibits the lowest coefficient of friction and the highest wear resistance among the examples of the present invention.

(Density of Coating)

It is preferred that the coating has a density of 2.6 to 3.6 g/ cm$^3$ in view of lower coefficient of friction and improved wear resistance. Especially it is desired that the coating substantially consists of carbon only with the density being within this range. The density measurement is calculated by dividing the change in weight of the sample (substrate and film) before and after film formation by deposition volume. Alternatively, the density may effectively be calculated by plasmon energy in EELS (Electronic Energy Loss Spectrum) or XPS (X-ray Photoelectronic Spectrum).

(Ratio of SP$^2$ Bond)

It is desired that carbon component having SP$^2$ bond in the hard coating is 1 to 40 at.%. It has been already described that SP$^2$ bond has an influence on the wear resistance and the coefficient of friction of coating in the presence of a lubricant oil. The carbon component having SP$^2$ bond within the range described above is effective to attain the low coefficient of friction and high wear resistance. Various methods have been proposed for determining the ratio of existence of the bond. In the present invention, the peak intensity derived from SP$^2$ bonded carbon in a sample spectrum measured by EELS is standardized by peak intensity of graphite (SP$^2$ ratio is 100 at.%) to find SP$^2$ ratio.

(Thickness of Coating)

It is preferred that the thickness of the coating as a whole (when there is an intermediate layer, which will be described later, the thickness of the intermediate layer is not included) is 0.05 to 100 μm. When the thickness is smaller than 0.05 μm, the period in which the coefficient of friction can be reduced in the sliding state is too short to be practical. When the thickness exceeds 100 μm, the coating becomes fragile and easy to be damaged. Preferable range is 0.05 μm to 10 μm and more preferable range is 0.1 μm to 10 μm.

(Substrate)

The hard coating described above is formed on a substrate. The suitable substrate is a component part of an internal combustion engine. The application to a component requiring high durability such as mechanical parts and the sliding parts using in high load condition is preferred, rather than the field where the load is light, such as a magnetic recording medium.

The substrate is not specifically limited. At least one selected from the group consisting of ceramics, iron based alloy, aluminum alloy and iron based sintered body is suitable. The ceramics may include silicon nitride, alumina and zirconia. The iron based alloy may include high speed tool steel, stainless steel and SKD. An aluminum alloy may include duralumin. Further, WC based cemented carbide and cermet may be used. The type of the substrate is expressed based on the Japanese Industrial Standards.

(Formation of Intermediate Layer)

The coating described above may directly be formed on a substrate. Provision of an intermediate layer 12 (see Figs. 1 and 2) between the substrate and the coating, however, is preferable to improve adhesion between the two. As to the material of the intermediate layer, a material having the coefficient of linear expansion between that of the substrate and that of the coating is preferable. For example, at least one material selected from IVa, Va, VIa group elements of the periodic table, ion group metal, Al and Si as well as a carbide, a nitride and a nitrided carbide of these elements may be used. Though a single layer of an element of IVa, Va, VIa groups of the periodic table, nitride, carbide or nitrided carbide of these elements may be effective as the intermediate layer, it is more effective to provide a layer formed of an element of IVa, Va or VIa group of the periodic table or Si (metal layer) on the surface of the substrate and to provide a nitride, a carbide or nitrided carbide layer (compound layer) of these elements on the coating side. In this case, it is effective that the transition from the metal layer to the compound layer is continuous in composition. Namely, the carbon or nitride content is adapted to change continuously. Transition from the compound layer to a carbon layer may also be stepwise in composition or the carbon content may continuously increase. The thickness of the intermediate layer should preferably be 0.01 $\mu$m to 1 $\mu$m, in order to improve adhesion between the coating and the substrate.

(Method of Forming the Coating)

Means to form the coating (including the intermediate layer) may be RF plasma CVD, DC magnetron, unbalanced magnetron sputtering, vacuum arc discharge deposition, ion beam deposition, laser aberration and the like.

The film in which particles of other compound are included can be formed by mainly changing the material of film formation and the supply time. When a film grows, nuclei are formed on the surface of the substrate, which nuclei grow to a number of islands. Each of the islands grows and is integrated with adjacent islands, whereby a layer is formed. Therefore, when a film is formed by a different material before each of the islands is integrated with adjacent islands to form a film of the different material between the islands, when viewed three-dimensionally, the portion contain particles of the other compound composed in the different material.

The coating having a stacked structure can be formed. After one raw material formed one layer, the other material was supplied and formed the other layer. Such steps were repeated.

(Portion where the Coating is to be Formed)

The portion where the coating is to be formed is that portion which requires wear resistance. For example, the surface sliding over the counterpart of the substrate, that is, the entire sliding surface is preferred. Dependent on the shape of the substrate, for example, the coating may be provided only on a part of the sliding surface.

As described above, according to the present invention, by providing a coating mainly consisting of carbon on a surface of a substrate and using the same in the presence of a lubricant, the coefficient of friction can be reduced and wear resistance can be improved. Therefore, application to a sliding member used in the presence of a lubricant oil in industry and at homes is expected, to improve wear resistance, sliding characteristics, corrosion resistance and the function of surface protected. Especially, application to automobile engines, fuel pumps and sliding portions of various machines is expected.

The foregoing and other objects, features, aspects and advantages of the present invention will become more apparent from the following detailed description of the present invention when taken in conjunction with the accompanying drawings, provided by way of example.

Fig. 1 is a cross section of a sliding member in accordance with the present invention having a coating formed of DLC only.

Fig. 2 is a cross section of a sliding member in accordance with the present invention having a coating in which DLC and other compound are bonded.

Fig. 3A is a cross section of a sliding member in accordance with the present invention in which particles of other compound are composed in a layer formed of DLC only, and Fig. 3B is a cross section of a sliding member in accordance with the present invention having a stacked structure including the layer formed of DLC only and other compound layer.

Fig. 4A is a cross section of a sliding member in accordance with the present invention in which particles are composed in the remaining portion, and Fig. 4B is a cross section of a sliding member in accordance with the present invention having a stacked structure of first and second layers.

Fig. 5 is a schematic diagram of an RF excited plasma CVD apparatus.

Fig. 6 is as schematic diagram of a vacuum arc discharge deposition apparatus.

Fig. 7 is a graph representing a relation between the Knoop hardness and the coefficient of friction of coatings.

Fig. 8 is a graph representing a relation between the hardness and the coefficient of friction of the coating in accordance with the present invention with intermediate layers.

Fig. 9 is a graph representing a relation between the hardness and the coefficient of friction of the coatings of which Knoop hardness is 2000 to 6000 kg/mm$^2$ and Ra is 0.005 to 0.2 $\mu$m.

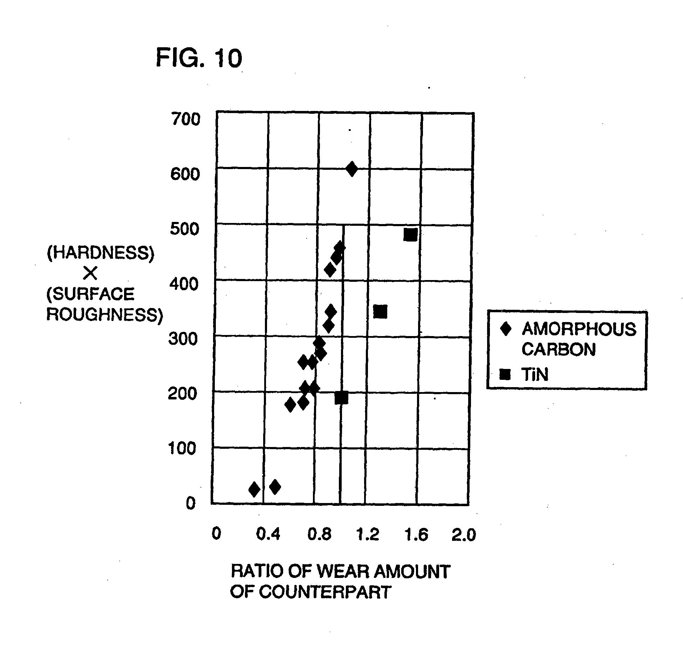

Fig. 10 is a graph representing a relation between Ra $\times$ Hk and the ratio of the amount of wear.

Fig. 11 is a graph representing a relation between the hardness and the coefficient of friction of the coatings in accordance with the present invention with intermediate layers.

Fig. 12 is a graph representing a relation between the stress and SP$^3$ peak position.

Embodiments of the present invention will be described in the following.

Coating samples mainly consisting of carbon were formed on substrates with or without an intermediate layer, and presence/absence of peeling of the coating, the coefficient of friction and the wear amount were studied. The following conditions were common to Examples 1 to 4, which will be described later.

WC based cemented carbide, silicon nitride ($Si_3N_4$), alumina ($Al_2O_3$), Al based alloy, SKH51, SUS304c and SCM415 were used as the substrates.

As to the method of film formation of the coating, RF plasma CVD (RF-CVD), ion plating (IP), vacuum arc discharge deposition (VAD) and sputtering (SP) were adopted. RF-CVD/IP represents both methods utilized together. When RF-CVD is adopted, hydrogen carbide gas ($CH_4$), ammonia or $N_2$ and hydrogen were used. When a metal element was added, the metal was added in the form of a chloride or an alkoxide in a gas phase, or a solid raw material was evaporated. In the VAD method, solid evaporation source metal or ceramics was used with the atmosphere gas being hydrogen carbide-Ar based gas, solid evaporation source of carbon and metal or ceramic were used for film formation in Ar based gas atmosphere or without atmosphere gas. In the SP method, RF-magnetron sputtering was adopted, in which solid evaporation source of carbon and metal or ceramics were sputtered in Ar atmosphere. Specific conditions and ranges for the respective methods of film formation are as shown in Tables 1 to 4. Table 1 represents conditions for RF-CVD, Table 2 represents conditions for VAD, Table 3 represents conditions for SP and Table 4 represent conditions for IP.

Table 1

| RF-CVD | | |
| --- | --- | --- |
| RF power | W | 100~800 |
| gas sources | | $CH_4$, $C_2H_2$, $C_6H_6$ |
| pressure | Pa | 0.133~133 |
| heater temperature | °C | 25~500 |

Table 2

| Vacuum arc discharge deposition | | |
| --- | --- | --- |
| cathode current | A | 30~120 |
| substrate bias | V | -800~0 |
| gas pressure (when Ar is introduced) | Pa | 0.2~8 |

(continued)

| Vacuum arc discharge deposition | | |
|---|---|---|
| number of rotation of substrate holder | rpm | 0~30 |

Table 3

| Sputtering | | |
|---|---|---|
| suputter power | W | 200~800 |
| bias applied to substrate | W | 0~200 |
| gas pressure | Pa | 0.02~8 |
| number of rotation of substrate holder | rpm | 0~30 |
| heater temperature | °C | 25~00 |

Table 4

| Ion plating | | |
|---|---|---|
| electron beam current | mA | 20~300 |
| bias applied to substrate | W | 0~800 |
| gas pressure (when Ar is introduced) | Pa | 0.002~8 |
| number of rotation of substrate holder | Rpm | 0~30 |
| heater temperature | °C | 25~500 |

TiN, TiCN, $Al_2O_3$, SiC and the like were used as the materials of the intermediate layer, and the thickness of the intermediate layer was in the range of about 0.05 to 1.5 $\mu$m.

The sliding members used for evaluating wear were the samples on which peeling was not observed after film formation or the sample of which substrate itself was not changed in quality. Tables 5 to 10 represent the results of evaluation, where ○ represents those samples which could be evaluated, and × represent those not. The evaluation was performed by the ball-on-disk test. The counterpart was a SUJ2 ball of $\phi$6 mm, sliding radius was 1 mm, the number of rotation was 500 rpm, total number of rotation was 10000, load was 10N and the test was conducted in engine oil (SAE10W-30), and the friction force was measured. The types of the engine oil are shown in expressions determined by Society of Automotive Engineers (SAE) . The "SUJ2" is an expression based on the Japanese Industrial Standards. The coefficient of friction was calculated, cross sectional area of the wear trace or dent after the end of test was measured by a surface roughness gauge, and wear resistance was evaluated. For comparison, Comparative Example 1 was also prepared which did not have any coating formed on the substrate of SUS304. Wear resistance is represented as the ratio of cross sectional area of the wear trace or dent in each sample, where the cross section of the wear trace or dent of DLC as Comparative Example 1 is 100. The column "amount of wear" in each table represents the ratio of the cross sectional area. The ratio of cross sectional areas of the wear trace and the coefficient of friction represent average value of the samples which could be evaluated. Further, the column "additive/no additive" represents whether dodecylbenzene was added or not added to engine oil. The ratio of carbon forming benzene nuclei of dodecylbenzene to the total amount of carbon in the lubricant oil was 10 wt%.

(Test Example 1)

The above described test was conducted on samples having such coating structures as shown in Figs. 1 and 2. The results are as shown in Table 5. "Other compound" in each sample of Table 5 was amorphous. In sputtering or vacuum arc discharge deposition, "other compound" can be made amorphous, by simultaneously discharging respective evaporation sources.

Table 5

| | Element(s) of Coating | Method of Formation | Intermediate Layer | Film thickness ($\mu$m) | No additive Coefficient of Friction | Additive Coefficient of Friction | Additive Amount of Wear | WC Cemented Carbide | $Si_3N4$ | $Al_2O_2$ | Al Based Alloy | SKH 51 | SUS 3O4c | SCM 415 |
|---|---|---|---|---|---|---|---|---|---|---|---|---|---|---|
| 1-1 | C | VAD | provided | 3.6 | 0.06 | 0.04 | 6 | ○ | ○ | ○ | ○ | ○ | ○ | ○ |
| 1-2 | C | VAD | | 5.7 | 0.05 | 0.04 | 7 | ○ | ○ | ○ | ○ | ○ | ○ | ○ |
| 1-3 | C | VAD | provided | 4 | 0.07 | 0.04 | 6 | ○ | ○ | ○ | ○ | ○ | ○ | ○ |
| 1-4 | C | RF-CVD/IP | provided | 2 | 0.05 | 0.03 | 5 | ○ | ○ | ○ | × | × | × | × |
| 1-5 | C | SP | provided | 3 | 0.05 | 0.02 | 6 | ○ | ○ | ○ | ○ | ○ | ○ | ○ |
| 1-6 | C,Si | SP | provided | 2.5 | 0.05 | 0.02 | 7 | ○ | ○ | ○ | ○ | ○ | ○ | ○ |
| 1-7 | C,Si | SP | provided | 0.7 | 0.05 | 0.03 | 7 | ○ | ○ | ○ | ○ | ○ | ○ | ○ |
| 1-8 | C,Si | SP | | 1.6 | 0.06 | 0.03 | 4 | ○ | ○ | ○ | ○ | ○ | ○ | ○ |
| 1-9 | C,Ti | VAD | provided | 15 | 0.05 | 0.02 | 6 | ○ | ○ | ○ | ○ | ○ | ○ | ○ |
| 1-10 | C,Ti | VAD | provided | 2 | 0.05 | 0.02 | 6 | ○ | ○ | ○ | ○ | ○ | ○ | ○ |
| 1-11 | C,Ti | SP | provided | 2 | 0.05 | 0.02 | 4 | ○ | ○ | ○ | ○ | ○ | ○ | ○ |
| 1-12 | C,Ti | RF-CVD/IP | provided | 2.6 | 0.06 | 0.02 | 4 | ○ | ○ | ○ | × | × | × | × |
| 1.13 | C,Cr | RF-CVD/IP | provided | 4 | 0.06 | 0.02 | 4 | ○ | ○ | ○ | × | × | × | × |
| 1-14 | C,Cr | VAD | provided | 3.6 | 0.05 | 0.02 | 4 | ○ | ○ | ○ | ○ | ○ | ○ | ○ |
| 1-15 | C,Cr,Ti | VAD | provided | 5.8 | 0.05 | 0.04 | 4 | ○ | ○ | ○ | ○ | ○ | ○ | ○ |
| 1-16 | C,Cr,Al | VAD | | 3.4 | 0.05 | 0.04 | 5 | ○ | ○ | ○ | ○ | ○ | ○ | ○ |
| 1-17 | C,Ta | VAD | provided | 8.1 | 0.06 | 0.02 | 8 | ○ | ○ | ○ | ○ | ○ | ○ | ○ |
| 1-18 | C,Ta | VAD | provided | 4 | 0.05 | 0.02 | 8 | ○ | ○ | ○ | ○ | ○ | ○ | ○ |
| 1-19 | C,Ta | SP | provided | 0.9 | 0.05 | 0.04 | 5 | ○ | ○ | ○ | ○ | ○ | ○ | ○ |

(continued)

| | Element(s) of Coating | Method of Formation | Intermediate Layer | Film thickness (μm) | No additive Coefficient of Friction | Additive Coefficient of Friction | Additive Amount of Wear | WC Cemented Carbide | $Si_3N4$ | $Al_2O_2$ | Al Based Alloy | SKH 51 | SUS 3O4c | SCM 415 |
|---|---|---|---|---|---|---|---|---|---|---|---|---|---|---|
| 1-20 | C,Mo | VAD | provided | 0.8 | 0.06 | 0.03 | 7 | ○ | ○ | ○ | ○ | ○ | ○ | ○ |
| 1-21 | C,Mo | VAD | provided | 15 | 0.07 | 0.02 | 6 | ○ | ○ | ○ | ○ | ○ | ○ | ○ |
| 1-22 | C,Mo | SP | provided | 16 | 0.05 | 0.04 | 5 | ○ | ○ | ○ | ○ | ○ | ○ | ○ |
| 1-23 | C,W | VAD | provided | 10 | 0.06 | 0.03 | 4 | ○ | ○ | ○ | ○ | ○ | ○ | ○ |
| 1-24 | C,W | VAD | provided | 5.4 | 0.06 | 0.03 | 6 | ○ | ○ | ○ | ○ | ○ | ○ | ○ |
| 1-25 | C,W | VAD | provided | 2.3 | 0.06 | 0.04 | 4 | ○ | ○ | ○ | ○ | ○ | ○ | ○ |
| 1-26 | C,W | SP | provided | 1.2 | 0.05 | 0.02 | 5 | ○ | ○ | ○ | ○ | ○ | ○ | ○ |
| Comparative Example 1 | not provided | | not provided | | 0.1 | 0.1 | 100 | | | | | | | |

As can be seen from Table 5, Samples 1-1 to 1-5 were coatings consisting only of carbon, and Samples 1-6 to 1-23 were coatings in which the carbon forms a compound with other elements. It can be understood that in any of the samples, the coefficient of friction was decreased when dodecylbenzene was contained in the lubricant oil. As to the method of film formation, peeling of the coating was observed in some of the samples prepared by "RF-CVD/IP", and therefore methods of film formation other than this combination is preferable.

(Test Example 2)

The above described test was conducted on the samples having such coating structure as shown in Fig. 3A. More specifically, in the samples, the coating consisting of DLC only includes particles of other compound composed therein. Tables 6 and 7 represent the results of the test. In the tables, "elements of other compound" represent the elements constituting "other compound particles 5" in Figs. 3A, and "grain diameter" represents outer diameter thereof.

Table 6

| | Elements of other Compound | Method of Formation | Intermediate Layer | Grain Diameter (nm) | Film Tickness ($\mu$m) | No Additive | Additive | | WC Cemented Carbide | Si$_2$N$_4$ | Al$_2$O$_2$ | Al Based Alloy | SKH51 | SUS 3O4c | SCM 415 |
| | | | | | | Coefficient of Friction | CoeffiCient of Friction | Amount of Wear | | | | | | | |
|---|---|---|---|---|---|---|---|---|---|---|---|---|---|---|---|
| 2-1 | Si | RF-CVD | provided | 820 | 26 | 0.04 | 0.03 | 5 | ○ | ○ | × | × | × | × | × |
| 2-2 | Si | RF-CVD | provided | 1260 | 45 | 0.05 | 0.03 | 6 | ○ | ○ | × | × | × | × | × |
| 2-3 | Si | SP | provided | 10 | 1 | 0.06 | 0.03 | 6 | ○ | ○ | ○ | ○ | ○ | ○ | ○ |
| 2-4 | Ti | VAD | provided | 9 | 3.5 | 0.04 | 0.02 | 7 | ○ | ○ | ○ | ○ | ○ | ○ | ○ |
| 2-5 | Ti | VAD | provided | 35 | 2 | 0.04 | 0.03 | 5 | ○ | ○ | ○ | ○ | ○ | ○ | ○ |
| 2-6 | Ti | SP | provided | 44 | 1 | 0.05 | 0.03 | 4 | ○ | ○ | ○ | ○ | ○ | ○ | ○ |
| 2-7 | Cr | VAD | provided | 86 | 9.3 | 0.05 | 0.03 | 6 | ○ | ○ | ○ | ○ | ○ | ○ | ○ |
| 2-8 | Cr | SP | provided | 9 | 08 | 0.05 | 0.03 | 5 | ○ | ○ | ○ | ○ | ○ | ○ | ○ |
| 2-9 | Cr | RF-CVD/IP | provided | 21 | 1 | 0.06 | 0.03 | 5 | ○ | ○ | × | × | × | × | × |
| 2-10 | Ta | VAD | provided | 10 | 5.3 | 0.05 | 0.03 | 7 | ○ | ○ | ○ | ○ | ○ | ○ | ○ |
| 2-11 | Ta | VAD | | 43 | 4.3 | 0.04 | 0.02 | 8 | ○ | ○ | ○ | ○ | ○ | ○ | ○ |
| 2-12 | Ta | SP | provided | 9 | 1.3 | 0.05 | 0.02 | 6 | ○ | ○ | ○ | ○ | ○ | ○ | ○ |
| 2-13 | Ta | RF-CVD/IP | provided | 36 | 1 | 0.04 | 0.02 | 5 | ○ | ○ | × | × | × | × | × |
| 2-14 | Mo | RF-CVD/IP | provided | 59 | 4.1 | 0.05 | 0.02 | 6 | ○ | ○ | × | × | × | × | × |
| 2-15 | Mo | VAD | provided | 57 | 10 | 0.04 | 0.02 | 8 | ○ | ○ | ○ | ○ | ○ | ○ | ○ |
| 2-16 | W | VAD | provided | 13 | 13 | 0.04 | 0.03 | 4 | ○ | ○ | ○ | ○ | ○ | ○ | ○ |
| 2-17 | W | VAD | provided | 60 | 12.5 | 0.04 | 0.02 | 6 | ○ | ○ | ○ | ○ | ○ | ○ | ○ |
| 2-18 | W | RF-CV/IP | | 34 | 2.3 | 0.06 | 0.04 | 8 | ○ | ○ | × | × | × | × | × |
| 2-19 | W | SP | | 9 | 14 | 0.04 | 0.02 | 8 | ○ | ○ | ○ | ○ | ○ | ○ | ○ |
| 2-20 | C,Si | SP | provided | 20 | 1 | 0.04 | 0.02 | 5 | ○ | ○ | ○ | ○ | ○ | ○ | ○ |
| 2-21 | C,Si | RF-CVD/IP | | 33 | 1.5 | 0.05 | 0.03 | 5 | ○ | ○ | × | × | × | × | × |

(continued)

| | Elements of other Compound | Method of Formation | Intermediate Layer | Grain Diameter (nm) | Film Tickness ($\mu$m) | No Additive | Additive | | WC Cemented Carbide | Si$_2$N$_4$ | Al$_2$O$_2$ | Al Based Alloy | SKH51 | SUS 3O4c | SCM 415 |
|---|---|---|---|---|---|---|---|---|---|---|---|---|---|---|---|
| | | | | | | Coefficient of Friction | CoeffiCient of Friction | Amount of Wear | | | | | | | |
| 2-22 | C,Si | RF-CVD | provided | 570 | 14 | 0.05 | 0.03 | 7 | ○ | ○ | × | × | × | × | × |
| 2-23 | C,Ti | VAD | provided | 13 | 5.8 | 0.05 | 0.02 | 6 | ○ | ○ | ○ | ○ | ○ | ○ | ○ |
| 2-24 | C,Ti | VAD | provided | 37 | 62 | 0.06 | 0.03 | 5 | ○ | ○ | ○ | ○ | ○ | ○ | ○ |
| 2-25 | C,Ti | SP | provided | 15 | 2 | 0.04 | 0.03 | 5 | ○ | ○ | ○ | ○ | ○ | ○ | ○ |
| 2-26 | C,Ti | RF-CVD/IP | | 62 | 1.2 | 0.04 | 0.02 | 5 | ○ | ○ | × | × | × | × | × |

EP 2 000 560 B1

Table 7

| | Elements of other Compound | Method of Formation | Intermediate Layer | Grain Diameter (nm) | Film Thickness ($\mu$m) | No Additive Coefficient of Friction | Additive Coefficient or Friction | Additive Amount of Wear | WC Cemented Carbide | $Si_3N_4$ | $Al_3O_2$ | Al Based Alloy | SKH 51 | SUS 3O4c | SCM 415 |
|---|---|---|---|---|---|---|---|---|---|---|---|---|---|---|---|
| 2-27 | C,Cr | VAD | provided | 61 | 1.3 | 0.05 | 0.03 | 7 | ○ | ○ | ○ | ○ | ○ | ○ | ○ |
| 2-28 | C,Cr | RF-CVD/IP | | 28 | 2.5 | 0.05 | 0.03 | 5 | ○ | ○ | × | × | × | × | × |
| 2-29 | C,Ta | VAD | provided | 12 | 3.4 | 0.05 | 0.03 | 4 | ○ | ○ | ○ | ○ | ○ | ○ | ○ |
| 2-30 | C,Ta | VAD | provided | 29 | 62 | 0.05 | 0.02 | 5 | ○ | ○ | ○ | ○ | ○ | ○ | ○ |
| 2-31 | C,Mo | VAD | provided | 66 | 56 | 0.06 | 0.03 | 5 | ○ | ○ | ○ | ○ | ○ | ○ | ○ |
| 2-32 | C,Mo | SP | provided | 42 | 12 | 0.06 | 0.04 | 5 | ○ | ○ | ○ | ○ | ○ | ○ | ○ |
| 2-33 | C,W | SP | | 63 | 1 | 0.05 | 0.04 | 6 | ○ | ○ | ○ | ○ | ○ | ○ | ○ |
| 2-34 | C,W | VAD | provided | 41 | 4.2 | 0.04 | 0.02 | 7 | ○ | ○ | ○ | ○ | ○ | ○ | ○ |
| 2-35 | C,W | VAD | provided | 13 | 4.5 | 0.06 | 0.03 | 4 | ○ | ○ | ○ | ○ | ○ | ○ | ○ |
| 2-36 | C,W | SP | provided | 23 | 1.6 | 0.06 | 0.03 | 6 | ○ | ○ | ○ | ○ | ○ | ○ | ○ |
| 2-37 | C,W | RF-CVD/IP | | 34 | 2.4 | 0.05 | 0.02 | 8 | ○ | ○ | × | × | × | × | × |
| 2-38 | N,Si | SP | provided | 17 | 1.6 | 0.05 | 0.02 | 5 | ○ | ○ | ○ | ○ | ○ | ○ | ○ |
| 2-39 | N,Ti | VAD | provided | 65 | 8 | 0.05 | 0.02 | 4 | ○ | ○ | ○ | ○ | ○ | ○ | ○ |
| 2-40 | N,Cr | VAD | provided | 40 | 10 | 0.05 | 0.02 | 5 | ○ | ○ | ○ | ○ | ○ | ○ | ○ |
| 2-41 | N,Ta | VAD | provided | 25 | 2 3 | 0.06 | 0.03 | 6 | ○ | ○ | ○ | ○ | ○ | ○ | ○ |
| 2-42 | N,Mo | VAD | provided | 31 | 5 | 0.05 | 0.03 | 5 | ○ | ○ | ○ | ○ | ○ | ○ | ○ |
| 2-43 | N,W | VAD | provided | 65 | 5.6 | 0.05 | 0.03 | 8 | ○ | ○ | ○ | ○ | ○ | ○ | ○ |
| 2-44 | C,N,Si | SP | provided | 10 | 1 | 0.05 | 0.02 | 5 | ○ | ○ | ○ | ○ | ○ | ○ | ○ |
| 2-45 | C,N,Ti | VAD | provided | 37 | 2.1 | 0.05 | 0.03 | 6 | ○ | ○ | ○ | ○ | ○ | ○ | ○ |
| 2-46 | C,N,Ti | VAD | provided | 9 | 6 | 0.04 | 0.03 | 7 | ○ | ○ | ○ | ○ | ○ | ○ | ○ |

(continued)

| | Elements of other Compound | Method of Formation | Intermediate Layer | Grain Diameter (nm) | Film Thickness (μm) | No Additive Coefficient of Friction | Additive Coefficient or Friction | Additive Amount of Wear | WC Cemented Carbide | Si$_3$N$_4$ | Al$_3$O$_2$ | Al Based Alloy | SKH 51 | SUS 3O4c | SCM 415 |
|---|---|---|---|---|---|---|---|---|---|---|---|---|---|---|---|
| 2-47 | C,N,Ti | SP | provided | 20 | 16 | 0.05 | 0.03 | 5 | ○ | ○ | ○ | ○ | ○ | ○ | ○ |
| 2-48 | C,N,Cr | VAD | provided | 10 | 7.6 | 0.04 | 0.03 | 8 | ○ | ○ | ○ | ○ | ○ | ○ | ○ |
| 2-49 | C,N,Cr | SP | Provided | 14 | 1 | 0.05 | 0.03 | 5 | ○ | ○ | ○ | ○ | ○ | ○ | ○ |
| 2-50 | C,N,Ta | VAD | provided | 32 | 5.5 | 0.05 | 0.04 | 4 | ○ | ○ | ○ | ○ | ○ | ○ | ○ |
| 2-51 | C,N,Mo | RF-CVD/IP | provided | 34 | 2.2 | 0.05 | 0.02 | 6 | ○ | ○ | × | × | × | × | × |
| 2-52 | C,N,W | VAD | provided | 36 | 1.6 | 0.05 | 0.03 | 5 | ○ | ○ | ○ | ○ | ○ | ○ | ○ |

As shown in Tables 6 and 7, in any of the samples, the coefficient of friction was decreased when dodecylbenzene was contained in the lubricant oil. As to the method of film formation, peeling of the coating was observed in some of the samples preferred by "RF-CVD/IP", and therefore other methods of film formation are preferred. Peeling of coating was not observed regardless of the method of film formation when the substrate was WC based cemented carbide, $Si_3N_4$ or $Al_2O_3$.

(Test Example 3)

The above described test was conducted on the samples having such a coating structure as shown in Fig. 3B. In the present test, intermediate layers were formed on the samples. Tables 8 and 9 represent the result of the test. In the tables, "elements of other compound" represents the elements constituting "other compound layer 7" of Fig. 3B, "thickness of other compound layer" represents thickness per one layer of "other compound layer 7", "carbon layer thickness" represents thickness per one layer of "coating layer 6 consisting of DLC only", and "film thickness" represents the thickness of the coating as a whole. In the present test, peeling of the coating was not observed in any of the samples, regardless of the method of film formation. Therefore, the notation of whether the evaluation was possible or not (O/X) is omitted.

Table 8

| | Elements of other Compound | Method of Formation | Thickness of other Compound Layer (nm) | Carbon Layer Thickness (nm) | Film Thickness ($\mu$m) | No Additive | Additive | |
|---|---|---|---|---|---|---|---|---|
| | | | | | | Coefficient of Friction | Coefficient of Friction | Amount of Wear |
| 3-1 | Si | SP | 2 | 2 | 1.5 | 0.05 | 0.03 | 6 |
| 3-2 | Si | SP | 12 | 24 | 1.5 | 0.05 | 0.03 | 8 |
| 3-3 | Si | SP | 73 | 140 | 1.4 | 0.04 | 0.03 | 7 |
| 3-4 | Ti | VAD | 2 | 4 | 3.2 | 0.03 | 0.02 | 6 |
| 3-5 | Ti | VAD | 15 | 7 | 3.2 | 0.06 | 0.04 | 5 |
| 3-6 | Ti | SP | 46 | 7 | 1.4 | 0.07 | 0.06 | 7 |
| 3-7 | Cr | VAD | 2 | 10 | 5.1 | 0.04 | 0.03 | 6 |
| 3-8 | Cr | VAD | 15 | 10 | 5 | 0.03 | 0.02 | 8 |
| 3-9 | Ta | SP | 86 | 52 | 6 | 0.06 | 0.04 | 8 |
| 3-10 | Ta | VAD | 15 | 31 | 8 | 0.05 | 0.04 | 8 |
| 3-11 | Mo | VAD | 2 | 2 | 8.2 | 0.04 | 0.03 | 7 |
| 3-12 | W | VAD | 2 | 2 | 8 | 0.05 | 0.04 | 6 |
| 3-13 | W | VAD | 15 | 2 | 7.6 | 0.05 | 0.04 | 7 |
| 3-14 | W | SP | 70 | 6 | 1.7 | 0.05 | 0.04 | 8 |
| 3-15 | C,Si | SP | 2 | 64 | 1 | 0.06 | 0.04 | 7 |
| 3-16 | C,Si | SP | 15 | 64 | 1.4 | 0.05 | 0.04 | 7 |
| 3-17 | C,Ti | VAD | 2 | 36 | 7 | 0.05 | 0.04 | 7 |
| 3-18 | C,Ti | VAD | 15 | 98 | 7 | 0.05 | 0.04 | 8 |
| 3-19 | C,Ti | SP | 86 | 96 | 1.6 | 0.05 | 0.04 | 7 |
| 3-20 | C,Cr | VAD | 2 | 13 | 1.3 | 0.05 | 0.04 | 7 |
| 3-21 | C,Cr | VAD | 15 | 14 | 1.3 | 0.03 | 0.02 | 5 |
| 3-22 | C,Cr | SP | 60 | 59 | 1.1 | 0.06 | 0.05 | 6 |
| 3-23 | C,Cr | SP | 3 | 3 | 1.4 | 0.06 | 0.04 | 8 |

(continued)

| | Elements of other Compound | Method of Formation | Thickness of other Compound Layer (nm) | Carbon Layer Thickness (nm) | Film Thickness (μm) | No Additive | Additive | |
|---|---|---|---|---|---|---|---|---|
| | | | | | | Coefficient of Friction | Coefficient of Friction | Amount of Wear |
| 3-24 | C,Ta | VAD | 10 | 46 | 6.8 | 0.04 | 0.03 | 8 |
| 3-25 | C,Mo | VAD | 16 | 46 | 7.4 | 0.05 | 0.04 | 7 |
| 3-26 | C,W | VAD | 4 | 26 | 8.5 | 0.05 | 0.04 | 8 |

Table 9

| | Elements of other Compound | Method of Formation | Thickness of other Compound Layer (nm) | Carbon Layer Thickness (nm) | Film Thickness (μm) | No Additive | Additive | |
|---|---|---|---|---|---|---|---|---|
| | | | | | | Coefficient of Friction | Coefficient of Friction | Amount of Wear |
| 3-27 | C,W | VAD | 10 | 26 | 8 | 0.06 | 0.04 | 8 |
| 3-28 | C,W | SP | 4 | 3 | 7.9 | 0.05 | 0.04 | 8 |
| 3-29 | N,Si | SP | 96 | 46 | 1 | 0.05 | 0.04 | 7 |
| 3-30 | N,Si | SP | 90 | 46 | 1 | 0.06 | 0.05 | 7 |
| 3-31 | N,Ti | VAD | 5 | 5 | 4.5 | 0.07 | 0.05 | 7 |
| 3-32 | N,Cr | VAD | 4 | 4 | 4.6 | 0.05 | 0.04 | 8 |
| 3-33 | N,Cr | VAD | 15 | 15 | 1 | 0.06 | 0.05 | 6 |
| 3-34 | N,Ta | SP | 85 | 20 | 0.8 | 0.05 | 0.04 | 6 |
| 3-35 | N,Ta | VAD | 60 | 23 | 4.3 | 0.05 | 0.03 | 7 |
| 3-36 | N,Mo | VAD | 4 | 1 | 5 | 0.06 | 0.05 | 8 |
| 3-37 | N,Mo | VAD | 15 | 3 | 2.3 | 0.05 | 0.04 | 5 |
| 3-38 | N,W | VAD | 13 | 16 | 9.8 | 0.06 | 0.05 | 6 |
| 3-39 | C,N,Si | SP | 32 | 23 | 1 | 0.05 | 0.04 | 8 |
| 3-40 | C,N,Si | SP | 83 | 23 | 1.3 | 0.07 | 0.05 | 7 |
| 3-41 | C,N,Ti | VAD | 52 | 48 | 1.3 | 0.06 | 0.04 | 5 |
| 3-42 | C,N,Ti | VAD | 4 | 6 | 4.5 | 0.05 | 0.03 | 6 |
| 3-43 | C,N,Cr | VAD | 3 | 2 | 10 | 0.06 | 0.04 | 7 |
| 3-44 | C,N,Cr | VAD | 16 | 16 | 1 | 0.07 | 0.06 | 7 |
| 3-45 | C,N,Ta | VAD | 15 | 6 | 5.8 | 0.05 | 0.04 | 5 |
| 3-46 | C,N,Mo | VAD | 2 | 13 | 6.3 | 0.05 | 0.03 | 6 |
| 3-47 | C,N,Mo | VAD | 8 | 16 | 2.4 | 0.04 | 0.03 | 8 |
| 3-48 | C,N,W | SP | 58 | 150 | 0.8 | 0.05 | 0.04 | 7 |
| 3-49 | C,N,W | VAD | 6 | 3 | 15 | 0.06 | 0.04 | 8 |

It can be seen from Tables 8 and 9 that in any of the examples, the coefficient of friction becomes lower than Comparative Example 1.

(Test Example 4)

The above described test was conducted on the samples having such a coating structure as shown in Fig. 4. In the present test, intermediate layer was formed on every sample. Table 10 represents the results of the test. In the present test, peeling of the coating was not observed in any of the samples, regardless of the methods of film formation. Therefore, notation of whether the evaluation was possible or not (O/X) is omitted. In this table, "layer 1" represents "remaining part 9" of Fig. 4A or "first layer 10" of Fig. 4B, and "layer 2" represent "particle portion 8" of Fig. 4A or "second layer 11" of Fig. 4B. Further, "structure of layer 1" and "structure of layer 2" represent which one of the structure shown in Figs. 2, 3A and 3B corresponds to each layer. Therefore, when the layer has the structure of Fig. 3A, the column "element of layer 1 or layer 2" represents the element constituting "other compound particles." Further, "film structure" represents whether the overall structure of the coating corresponds to Fig. 4A or Fig. 4B.

For example, in Sample No. 4-4, the overall structure is the stacked structure shown in Fig. 4B, "the first layer" is "the layer having particles of Cr composed in DLC" and "the second layer" is "a layer having particles of 'compound of C and Ti' composed in DLC". In Sample No. 4-1, the overall structure is the composite structure including particles shown in Fig. 4A, "remaining part" is formed of "a material having particles of Si composed in DLC", and further, "particle part" is formed of "a material having particles of 'compound of C and Si' composed in DLC".

Table 10

| | Element of Layer1 | Element of Layer2 | Structure of Layer 1 | Structture of Layer2 | Method of Formation | Film Structure | Film Thickness ($\mu$m) | No Additive | Additive | |
|---|---|---|---|---|---|---|---|---|---|---|
| | | | | | | | | Coefficient of Friction | Coefficient of Friction | Amount of Wear |
| 4-1 | Si | C,Si | Fig. 3A | Fig. 3A | SP | Fig. 4A | 1.5 | 0.05 | 0.04 | 6 |
| 4-2 | Ti | N,Ti | Fig.3A | Fig.3A | VAD | Fig.4A | 3.2 | 0.05 | 0.04 | 6 |
| 4-3 | Cr | C,Ti | Fig. 3A | Fig. 2 | VAD | Fig. 4B | 5.1 | 0.04 | 0.03 | 6 |
| 4-4 | Cr | C,Ti | Fig. 3A | Fig. 3A | VAD | Fig. 4B | 5 | 0.06 | 0.05 | 8 |
| 4-5 | Cr | C,Cr | Fie. 3A | Fig. 3A | VAD | Fig. 4B | 3.2 | 0.05 | 0.04 | 7 |
| 4-6 | Cr | C,Cr | Fig. 3B | Fig. 3A | VAD | Fig. 4B | 1.4 | 0.06 | 0.05 | 8 |
| 4-7 | Cr | N,Cr | Fig. 3A | Fig. 3A | VAD | Fig. 4B | 18 | 0.04 | 0.03 | 8 |
| 4-8 | Cr | N,C,Cr | Fig. 3A | Fig. 3B | VAD | Fig. 4B | 54 | 0.05 | 0.04 | 7 |
| 4-9 | W | W | Fig. 3A | Fig. 3B | VAD | Fig. 4B | 7.6 | 0.05 | 0.04 | 8 |
| 4-10 | C,Si | C,Ti | Fig. 2 | Fig. 3A | SP | Fig. 4A | 1 | 0.06 | 0.05 | 8 |
| 4-11 | C,Si | C,N,Ti | Fig. 3A | Fig. 3A | SP | Fig.4B | 1.4 | 0.05 | 0.04 | 8 |
| 4-12 | C,Ti | C,Cr | Fig. 2 | Fig. 2 | SP | Fig. 4A | 7.6 | 0.05 | 0.04 | 7 |
| 4-13 | C,Ti | C,Cr | Fig. 2 | Fig.2 | VAD | Fig. 4B | 19.8 | 0.06 | 0.04 | 7 |
| 4-14 | C,Ti | C,Cr | Fig. 3A | Fig. 2 | VAD | Fig. 4A | 2.3 | 0.05 | 0.04 | 7 |
| 4-15 | C,Ti | C,Cr | Fig. 3A | Fig. 2 | VAD | Fig. 4B | 4.6 | 0.05 | 0.04 | 6 |
| 4-16 | C,Ti | C,Cr | Fig. 3B | Fig. 2 | VAD | Fig. 4B | 10.1 | 0.05 | 0.04 | 9 |
| 4-177 | C,Ti | C,Cr | Fig. 3A | Fig. 3B | VAD | Fig. 4B | 30.4 | 0.04 | 0.03 | 9 |
| 4-18 | C,Cr | C,Cr,Al | Fig. 3A | Fig. 3B | VAD | Fig. 4B | 2.4 | 0.05 | 0.03 | 9 |
| 4-19 | C,Cr | N,Al,Ti | Fig. 2 | Fig. 3A | VAD | Fig. 4B | 8.6 | 0.04 | 0.03 | 7 |
| 4-20 | C,Cr | Al | Fig. 3A | Fig. 3B | VAD | Fig. 4B | 6.6 | 0.04 | 0.03 | 5 |
| 4-21 | C,Cr | C,N,Cr | Fig. 3B | Fig. 3B | VAD | Fig. 4B | 5.7 | 0.05 | 0.03 | 6 |
| 4-22 | C,Ta | C,N,Ta | Fig. 2 | Fig. 3B | VAD | Fig. 4B | 3.4 | 0.05 | 0.04 | 5 |
| 4-23 | C,Mo | N,Mo | Fig. 2 | Fig. 3A | VAD | Fig. 4A | 6.9 | 0.05 | 0.04 | 5 |

(continued)

| | Element of Layer1 | Element of Layer2 | Structure of Layer 1 | Structture of Layer2 | Method of Formation | Film Structure | Film Thickness (μm) | No Additive Coefficient of Friction | Additive Coefficient of Friction | Additive Amount of Wear |
|---|---|---|---|---|---|---|---|---|---|---|
| 4-24 | C,W | C,W | Fig. 2 | Fig. 3A | VAD | Fig.4B | 9.8 | 0.06 | 0.05 | 7 |
| 4-25 | C,W | C,W | Fig. 2 | Fig. 3B | VAD | Fig. 4B | 5.6 | 0.06 | 0.04 | 8 |
| 4-26 | C,W | C,W | Fig. 3A | Fig. 3B | VAD | Fig. 4B | 10.4 | 0.06 | 0.04 | 8 |
| 4-27 | N,Ti | N,Cr | Fig. 3B | Fig. 3B | VAD | Fig. 4B | 13.2 | 0.05 | 0.04 | 8 |

As can be seen from Table 10, the coefficient of friction of the examples of the present invention was lower than that of Comparative Example 1, and the amount of wear was smaller.

(Test Example 5)

Carbon films were formed on substrates by RF plasma CVD and vacuum arc discharge deposition, and test was conducted on the characteristics of the resulting coatings. Iron based alloy such as high speed tool steel, stainless steel and SKD, aluminum alloy and iron based sintered body were used as substrates. In order to clean the surface of the substrates, ultrasonic cleaning was conducted for more than ten minutes in acetone.

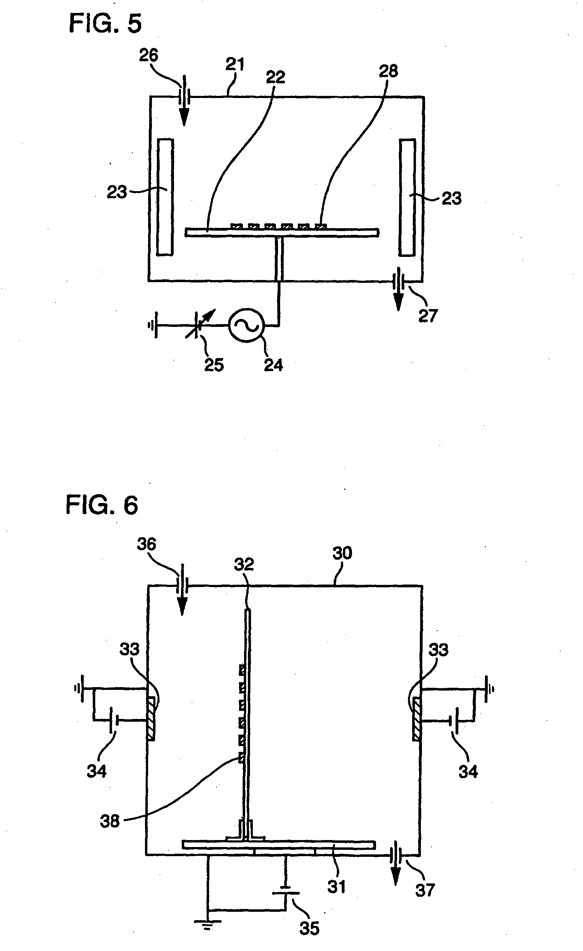

Fig. 5 shows an RF plasma CVD apparatus. The apparatus includes a substrate holder 22 in the shape of a horizontal plate in a vacuum chamber 21, and a heater 23 provided on a sidewall of the vacuum chamber surrounding the substrate holder 22. A high frequency power supply 24 and a DC power supply 25 are connected to substrate holder 22. Vacuum chamber 21 has a gas inlet 26 and a gas outlet 27.

When a film is formed by RF plasma CVD in such an apparatus, $CH_4$, $C_2H_2$ or $C_6H_6$ is used as the raw material gas. After the substrate 28 is set in substrate holder 22 in vacuum chamber 21, the apparatus is evacuated through gas outlet 27 to $2.7 \times 10^{-3}$ Pa. Heater 3 in the apparatus is heated to a prescribed temperature, and Ar gas is introduced through gas inlet 26 to vacuum chamber 21 so that atmospheric pressure in the apparatus attains 2.7Pa. Further, DC voltage of -100V is applied to substrate holder 22 to cause Ar plasma, and "Ar bombard process" takes place in which collision of Ar ions on substrate 28 removes dirt or contamination on the surface of the substrate. Thereafter, film formation was conducted under the condition of Table 11.

Table 11

| RF power | W | 200~600 |
|---|---|---|
| gas sources | | $CH_4$, $C_2H_2$, $C_6H_6$ |
| pressure | Torr | 0.2~0.001 |
| heater temperature | °C | 50~400 |

Fig. 6 shows a vacuum arc discharge deposition apparatus. The apparatus has a rotation table 31 of a horizontal disk shape in a vacuum chamber 30, and a substrate holder 32 is fixed vertically on rotation table 31. On a sidewall of the vacuum chamber surrounding the substrate holder 32, a target 33 (cathode electrode) is provided, and each target 33 is connected to a DC power supply 34. A prescribed voltage can be applied by DC power supply 35 connected to rotation table 31 to the substrate holder 32. Vacuum chamber 31 has a gas inlet 36 and a gas outlet 37.

In this apparatus, a solid carbon is used as target 33. After the substrate 38 is set in vacuum chamber 30, the apparatus is evacuated through gas outlet 37 to attain the pressure of not higher than $2.7 \times 10^{-3}$ Pa. Thereafter, Ar gas is introduced to vacuum chamber 30 through gas inlet 36, so as to attain 2.7Pa in the apparatus. At the same time, a DC voltage of - 1000V is applied to substrate holder 32 to perform Ar bombard processing. Thereafter, Ar gas is introduced to the vacuum chamber, or the gas is not introduced to the chamber and the chamber is evacuated. In this state, the hard carbon coating was formed under the conditions as shown in Table 12.

Table 12

| cathod current | A | 30~120 |
|---|---|---|
| substrate bias | V | -800~0 |
| gas pressure (when Ar is introduced) | Pa | 0.41~2.8 |
| number of rotation of substrate holder | rpm | 0~30 |

For measuring hardness, a Knoop indentator formed of diamond was used with the load of 50g, for the time of applying load of 10 seconds, and an average value of ten measurement points was taken. When the surface of the coating was too rough to observe the shape of the dent, buffing was performed using a diamond paste of #8000, so as to enable observation of the dent.

Surface roughness is an average value of eight measurement points with the measurement distance of 2.5 mm, speed of measurement of 0.3 mm/s and Cut-off value of 0.8 mm.

The coefficient of friction was measured by using a pin-on-disk tester. The conditions for the test were as follows: load weight was 10N, speed of rotation was104 mm/s, counterpart pin was made of SUJ2 having the diameter of 6 mm, and the coefficient of friction was measured in an engine oil atmosphere. The engine oil was SAE 10W-40SH, and the temperature of testing was room temperature.

The surface roughness of the carbon coating formed by RF plasma CVD was adjusted by lapping using abrasive materials or grinding on the surface of the substrate and varying the time of lapping and the grain diameter of abrasive materials. The surface roughness of a carbon film formed by vacuum arc discharge deposition was also changed mainly by the state of processing of the substrate surface. When the surface roughness Ra of smaller than 0.02 $\mu$m was to be attained, the surface of the carbon film was lapped by using diamond paste. These means for adjusting surface roughness were similarly applied in each of the examples which will be described later.

Table 13 shows surface roughness Ra, coating hardness, type of the substrates, film thickness and coefficient friction of coatings of which surface roughness Ra exceeds 0.2 $\mu$m and the Knoop hardness was in the range of 1800 to 8000 kg/mm$^2$. As a comparative example, the coefficient of friction of Comparative Example 5-1 having Ra exceeding 0.2 and Knoop hardness of 1738 was measured. The coating having the hardness of 1800 to 8000 is effective to reduce the coefficient of friction. The coatings in accordance with the present invention consisted of carbon by at least 60% in atomic percentage, and it was confirmed that the coatings of the present invention were amorphous, by XRD (X-ray Diffraction) analysis. This also  applied to the coatings in accordance with the present invention specified in Tables 14 and 15 as well as in the examples which will be described later.

Table 13

| | | Method of Film Formation | Knoop Hardness (kg/mm$^2$) | Surface Roughness Ra ($\mu$m) | Film Thickness ($\mu$m) | Substrate | Coefficient of Friction |
|---|---|---|---|---|---|---|---|
| Comparative Example 5-1 | | VAD | 1738 | 0.26 | 1.1 | SUS304 | 0.064 |
| * Samples of the Invention | 5-1 | RF-CVD | 4323 | 0.240 | 0.8 | SCM415 | 0.041 |
| | 5-2 | VAD | 3564 | 0.210 | 0.4 | SUS304 | 0.038 |
| | 5-3 | VAD | 5986 | 0.300 | 0.2 | SCM415 | 0.039 |
| | 5-4 | RF-CVD | 7230 | 0.260 | 0.4 | SUS304 | 0.038 |
| | 5-5 | VAD | 2345 | 0.240 | 0.1 | SKD11 | 0.044 |
| | 5-6 | VAD | 1983 | 0.250 | 0.4 | AC8A | 0.047 |
| *Reference Examples not forming part of the present invention. | | | | | | | |

Table 14 shows surface roughness Ra, coating hardness, types of the substrates, film thickness and coefficient of friction of coatings having Knoop hardness not higher than 1800 kg/mm$^2$ and Ra of 0.005 to 0.2 $\mu$m.

When compared with Comparative Example 5-1, the coefficient of friction is low. More specifically, when the hardness is not higher than 1800 kg/mm$^2$. the coating having Ra of 0.005 to 0.2 $\mu$m is effective to reduce the coefficient of friction.

Table 14

| | | Method of Film Formation | Knoop Hardness (kg/mm$^2$) | Surface Roughness Ra (nm) | Film Thickness ($\mu$m) | Substrate | Coefficient of Friction |
|---|---|---|---|---|---|---|---|
| Comparative Example 5-1 | | VAD | 1738 | 0.26 | 1.1 | SUS304 | 0.064 |

(continued)

|  |  | Method of Film Formation | Knoop Hardness (kg/mm$^2$) | Surface Roughness Ra (nm) | Film Thickness (μm) | Substrate | Coefficient of Friction |
|---|---|---|---|---|---|---|---|
| Samples of the Invention | 6-1 | RF-CVD | 1564 | 0.006 | 0.6 | SCM415 | 0.038 |
|  | *6-2 | RF-CVD | 1465 | 0.090 | 0.72 | SUS304 | 0.037 |
|  | *6-3 | RF-CVD | 1340 | 0.123 | 0.68 | S45C | 0.040 |
|  | 6-4 | VAD | 1124 | 0.034 | 0.8 | SCr415 | 0.042 |
|  | 6-5 | RF-CVD | 1667 | 0.062 | 0.45 | FC250 | 0.037 |
|  | 6-6 | VAD | 1788 | 0.083 | 0.97 | SCM415 | 0.088 |
| *Reference Examples. |  |  |  |  |  |  |  |

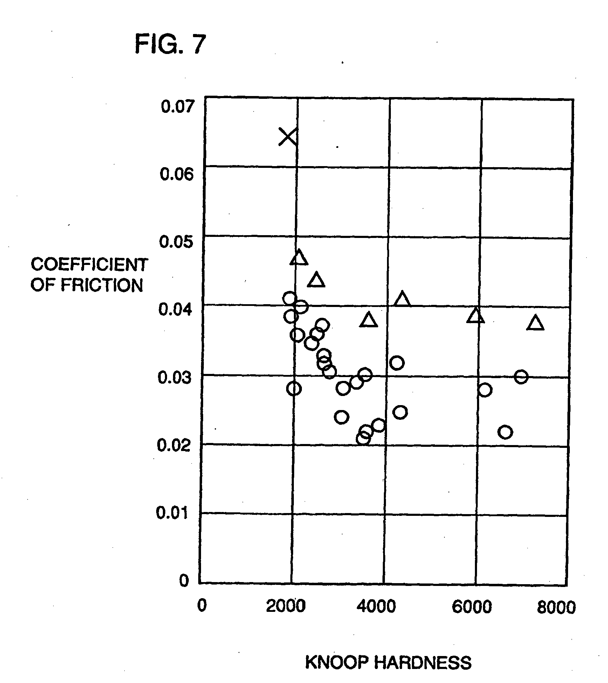

Table 15 shows surface roughness Ra, coating hardness, types of substrates, Film thickness and coefficient of friction of coatings having  Knoop hardness of 1800 to 8000 kg/mm$^2$ and Ra of 0.005 to 0.2 μm. Fig. 7 shows the relation between the hardness and the coefficient of friction. In the graph, Comparative Example 5-1 of Table 13 is represented by ×, the coating on which surface roughness Ra is exceeding 0.2 μm is represented by △ , and the coating having the surface roughness Ra of 0.005 to 0.2 μm are represented by ○. The coefficient of friction is the lowest when the Knoop hardness is 1800 to 8000 kg/mm$^2$ and Ra is 0.005 to 0.2μm.

Table 15

|  |  | Method of Film Formation | Knoop Hardness (kg/mm$^2$) | Surface Roughness Ra (μm) | Film Thickness (μm) | Substrate | Coefficient of Friction |
|---|---|---|---|---|---|---|---|
| Comparative Example 5-1 |  | VAD | 1738 | 0.26 | 1.1 | SUS304 | 0.064 |
| Samples of the Invention | *7.1 | RF-CVD | 2617 | 0.153 | 0.8 | SCM415 | 0.032 |
|  | *7-2 | RF-CVD | 6125 | 0.092 | 0.8 | SCM415 | 0.028 |
|  | *7-3 | RF-CVD | 6929 | 0.186 | 0.75 | AC8A | 0.030 |
|  | *7-4 | RF-CVD | 2685 | 0.115 | 0.8 | S45C | 0.031 |
|  | 7.5 | RF-CVD | 3293 | 0.078 | 0.9 | SCM415 | 0.029 |
|  | 7.6 | RF-CVD | 2969 | 0.063 | 0.9 | FC250 | 0.024 |
|  | 7-7 | RF-CVD | 1860 | 0.032 | 1 | SCM415 | 0.028 |
|  | 7.8 | RF-CVD | 2587 | 0.038 | 0.7 | SUS304 | 0.033 |
|  | *7.9 | RF-CVD | 2519 | 0.093 | 0.9 | SUS304 | 0.037 |
|  | 7-10 | RF-CVD | 3450 | 0.084 | 0.6 | S45C | 0.021 |
|  | *7-11 | VAD | 4263 | 0.098 | 0.7 | SCM415 | 0.025 |
|  | 7-12 | VAD | 1901 | 0.055 | 0.8 | SCM415 | 0.039 |
|  | 7.13 | VAD | 3763 | 0.017 | 0.5 | SCM415 | 0.023 |
|  | 7-14 | VAD | 4234 | 0.039 | 0.3 | AC8A | 0.032 |
|  | 7-15 | VAD | 2411 | 0.062 | 0.2 | SKD11 | 0.036 |
|  | 7-16 | VAD | 3489 | 0.034 | 0.15 | SCr415 | 0.022 |
|  | 7-17 | VAD | 2087 | 0.081 | 0.05 | SCM415 | 0.04 |
|  | 7-18 | VAD | 1823 | 0.083 | 0.01 | SCM415 | 0.041 |

(continued)

| | | Method of Film Formation | Knoop Hardness (kg/mm$^2$) | Surface Roughness Ra ($\mu$m) | Film Thickness ($\mu$m) | Substrate | Coefficient of Friction |
|---|---|---|---|---|---|---|---|
| | 7-19 | VAD | 2979 | 0.057 | 0.03 | SCM415 | 0.028 |
| | 7-20 | VAD | 6595 | 0.068 | 0.64 | SCM415 | 0.022 |
| | 7-21 | VAD | 1989 | 0.015 | 0.8 | S45C | 0.036 |
| | 7-22 | VAD | 2313 | 0.045 | 0.9 | SCr415 | 0.035 |
| | 7-23 | VAD | 3499 | 0.006 | 1 | SUS304 | 0.03 |
| *Reference Examples not forming part of the present invention | | | | | | | |

(Test Example 6)

First, in order to clean the surface of the substrate, ultrasonic cleaning is performed in acetone. Thereafter, various intermediate layers were formed by RF sputtering. The conditions of film formation were as follows: sputtering atmosphere gas was Ar gas, atmospheric pressure was 0.5Pa, atmospheric temperature was 400°C, the power applied to the target was 500W, and the power applied to the substrate holder was 20W. After the formation of the intermediate layers, amorphous carbon coatings were formed by RF plasma CVD or vacuum arc discharge deposition. The method of film formation and the conditions of film formation of RF plasma CVD and vacuum arc discharge deposition were the same as those of Test Example 5.

The measurement of the coefficient of friction was performed under the same conditions as the pin-on-disk test of Test Example 5.

Tables 16, 17 and 18 represent the test results of intermediate layers, intermediate layer thickness, surface roughness Ra, coating hardness, types of substrates and film thickness.

Table 16

| | | Type of Intermediate Layer | Thickness of Intermediate Layer ($\mu$m) | Method of Film Formation | Knoop Hardness (kg/mm$^2$) | Surface Roughness Ra ($\mu$m) | Film Thickness ($\mu$m) | Type of Substrate | Coefficient of Friction |
|---|---|---|---|---|---|---|---|---|---|
| Comparative Example 5-1 | | - | - | VAD | 1738 | 0.26 | 1.1 | SUS304 | 0.064 |
| Samples of the Invention | 8-1 | Ta | 0.37 | RF-CVD | 2565 | 0.26 | 0.5 | SCr536 | 0.047 |
| | 8-2 | W | 0.29 | RF-CVD | 5874 | 0.35 | 0.64 | S45C | 0.042 |
| | 8-3 | Si | 0.48 | VAD | 1856 | 0.24 | 0.8 | SUS304 | 0.045 |
| | 8-4 | Nb | 0.46 | VAD | 4632 | 0.3 | 0.7 | SUS304 | 0.043 |
| | 8-5 | Ti | 0.56 | VAD | 3671 | 0.24 | 0.8 | SKD11 | 0.044 |
| | 8.6 | Cr | 0.13 | VAD | 2546 | 0.31 | 1.7 | SCM415 | 0.042 |
| | 8-7 | Si | 0.55 | RF-CVD | 1125 | 0.04 | 0.6 | SCM415 | 0.042 |
| | 8-8 | W | 0.52 | RF-CVD | 1045 | 0.05 | 0.7 | AC8A | 0.043 |
| | 8-9 | Ti | 0.37 | RF-CVD | 1632 | 0.07 | 0.6 | SKH51 | 0.042 |
| | 8.10 | V | 0.54 | RF-CVD | 1524 | 0.14 | 0.9 | SCr436 | 0.041 |
| | 8-11 | Zr | 0.58 | VAD | 1273 | 0.06 | 0.6 | SCM415 | 0.041 |
| | *8-12 | Cr | 0.12 | VAD | 1436 | 0.113 | 1.2 | SCM415 | 0.04 |
| | 8-13 | Hf | 0.23 | VAD | 1353 | 0.05 | 0.7 | S45C | 0.042 |
| | 8-14 | Si | 0.21 | RF-CVD | 2019 | 0.016 | 0.8 | SCM415 | 0.034 |
| | 8-15 | Si | 0.8 | RF-CVD | 2999 | 0.016 | 0.8 | FC250 | 0.038 |
| | 8-16 | Si | 0.52 | RF-CVD | 4439 | 0.018 | 0.75 | SCM415 | 0.032 |
| | 8-17 | Ta | 0.67 | RF-CVD | 2401 | 0.036 | 0.8 | SCM415 | 0.042 |
| | 8-18 | Ta | 0.48 | RF-CVD | 2832 | 0.045 | 0.9 | S46C | 0.029 |
| | 8-19 | TaC | 0.22 | RF-CVD | 8499 | 0.035 | 0.9 | SCM415 | 0.022 |
| | 8-20 | W | 0.13 | RF-CVD | 2979 | 0.036 | 0.7 | SCM415 | 0.036 |
| *Reference Example | | | | | | | | | |

Table 17

| | | Type of Intermediate Layer | Thickness of Intermediate Layer (μm) | Method of Film formation | Knoop Hardness (kg/mm²) | Surface Roughness Ra (μm) | Film Thickness (μm) | Type of Substrate | Coefficient of Friction |
|---|---|---|---|---|---|---|---|---|---|
| Comparative Example 5-1 | | - | - | VAD | 1738 | 0.26 | 1.1 | SUS304 | 0.064 |
| Samples of the Invention | 8-21 | W carbide | 0.76 | RF-CVD | 3508 | 0.06 | 0.6 | SKD11 | 0.021 |
| | *8-22 | Cr | 0.13 | RF-CVD | 4586 | 0.092 | 0.8 | SCM415 | 0.024 |
| | *8-23 | Cr carbide | 0.11 | RF-CVD | 3788 | 0.125 | 0.7 | SCM415 | 0.023 |
| | 8-24 | Nb | 0.36 | RF-CVD | 1852 | 0.07 | 0.7 | SCM415 | 0.025 |
| | *8-25 | Nb | 0.44 | RF-CVD | 2617 | 0.089 | 0.8 | SCM415 | 0.041 |
| | 8-26 | Nb | 0.74 | RF-CVD | 3949 | 0.014 | 0.5 | FC260 | 0.028 |
| | 8-27 | Ti | 0.32 | RF-CVD | 1823 | 0.036 | 0.3 | SCM415 | 0.036 |
| | 8-28 | Ti | 0.55 | RF-CVD | 3097 | 0.036 | 0.15 | SCr436 | 0.022 |
| | 8-29 | Zr | 0.88 | RF-CVD | 2607 | 0.033 | 0.01 | SCM415 | 0.045 |
| | 8-30 | ZrC | 0.23 | RF-CVD | 1989 | 0.037 | 0.8 | AC8A | 0.037 |
| | 8-31 | TaC | 0.56 | RF-CVD | 4351 | 0.032 | 1 | SUS304 | 0.03 |
| | 8-32 | Hf | 0.58 | RF-CVD | 3499 | 0.068 | 1 | SCM415 | 0.03 |
| | 8-33 | Ta carbide | 0.43 | RF-CVD | 3273 | 0.056 | 0.3 | SCM415 | 0.033 |
| | 8-34 | Zr carbide | 0.33 | RF-CVD | 3361 | 0.007 | 0.8 | SKD11 | 0.033 |
| | 8-35 | Si | 0.54 | VAD | 2401 | 0.007 | 0.6 | SCM415 | 0.032 |
| | 8-36 | Si | 0.23 | VAD | 3175 | 0.054 | 0.7 | SKH51 | 0.038 |
| | 8-37 | Si | 0.67 | VAD | 4469 | 0.07 | 0.6 | SKH51 | 0.028 |
| | 8-38 | Ti | 0.98 | VAD | 2636 | 0.075 | 0.2 | SUS304 | 0.036 |
| | 8-39 | Ti | 0.65 | VAD | 3891 | 0.081 | 0.05 | SCM415 | 0.044 |
| | 8-40 | Ta | 0.64 | VAD | 2185 | 0.006 | 1 | SCM415 | 0.042 |

*Reference Example

EP 2 000 560 B1

27

Table 18

| | | Type of Intermediate Layer | Thickness of Intermediate Layer ($\mu$m) | Method of Film Formation | Knoop Hardness (kg/mm$^2$) | Surface Roughness Ra ($\mu$m) | Film Thickness ($\mu$m) | Type of Substrate | Coefficient of Friction |
|---|---|---|---|---|---|---|---|---|---|
| Comparative Example 5-1 | | - | - | VAD | 1738 | 0.26 | 1.1 | SUS304 | 0.064 |
| Samples of the Invention | *8-41 | W | 0.33 | VAD | 3940 | 0.124 | 0.8 | SUS304 | 0.037 |
| | 8-42 | W | 0.55 | VAD | 2607 | 0.024 | 0.9 | SKH51 | 0.042 |
| | 8-43 | Ti | 0.66 | VAD | 3175 | 0.03 | 0.7 | SKH51 | 0.086 |
| | 8-44 | Zr | 0.63 | VAD | 2778 | 0.009 | 0.6 | SUS304 | 0.04 |
| | 8-45 | Zr | 0.9 | VAD | 4665 | 0.06 | 0.03 | AC8A | 0.028 |
| | 8-46 | ZrC | 0.54 | VAD | 6595 | 0.06 | 0.64 | SCM415 | 0.041 |
| | 8-47 | Hf | 0.27 | VAD | 2313 | 0.049 | 0.9 | SCM415 | 0.036 |
| | *8-48 | Cr | 0.12 | VAD | 3798 | 0.087 | 0.6 | SCM415 | 0.031 |
| | 8-48 | V | 0.63 | VAD | 2877 | 0.079 | 0.7 | AC8A | 0.035 |
| | 8-50 | W carbide | 0.42 | VAD | 2283 | 0.063 | 0.1 | SUS304 | 0.041 |
| | 8-51 | Nb carbide | 0.52 | VAD | 3597 | 0.005 | 0.2 | SKH51 | 0.035 |
| | 8-52 | Ti carbide | 0.36 | VAD | 3146 | 0.06 | 0.7 | SKD11 | 0.032 |
| *Reference Example | | | | | | | | | |

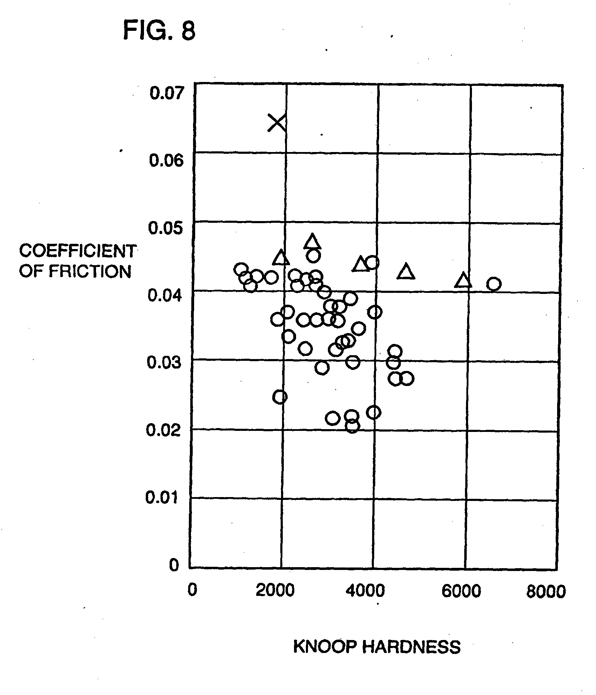

Fig. 8 shows the relation between the hardness and the coefficient of friction. In the graph, Comparative Example 5-1 of Table 13 is represented by the sign ×, the coating having surface roughness Ra exceeding 0.2 μm is represented by △ and the coating having surface roughness Ra of 0.005 to 0.2 μm is represented by ○. As in Test Example 5, the results also represented that the coefficient of Motion was the lowest when the Knoop hardness was between 1800 to 8000 kg/mm$^2$ and Ra was 0.005 to 0.2 μm. Therefore, introduction of an intermediate layer does not have any undesirable influence on the coefficient of friction.

(Test Example 7)

In order to calculate adhesion to the substrate, critical peeling load was measured by a scratch test. A diamond cone having the tip end diameter of 200 μm was pressed from the vertical direction and moved laterally. At this time, pushing load was increased by 11.5N/mm. AE (Acoustic Emission) when the substrate peels off from the film was detected by a sensor, and the pushing load when AE was generated was taken as the critical peeling load. As the actual portion of peeling is sometimes different from the portion where AE generates, final determination of the peeling load was made by visual observation.

As a test piece, a coating was used which had an intermediate layer formed on the substrate by sputtering and further an amorphous carbon coating formed thereon. Table 19 represents the results. As a comparative example, an amorphous carbon film formed directly on the substrate without any intermediate layer was also tested. It was found that by the introduction of the intermediate layer, adhesion was increased.

Table 19

| | | Type of Intermediate Layer | Thickness of Intermediate Layer (μm) | Method of Film Formation | Knoop Hardness (kg/mm$^2$) | Surface Roughness (μm) | Film Thickness (μm) | Type of Substrate | Coefficient of Friction | Critical Peeling Load (N) |
|---|---|---|---|---|---|---|---|---|---|---|
| Comparative Example 7-3 | | - | - | RF-CVD | 2664 | 0.045 | 0.8 | S45C | 0.034 | 15 |
| Comparative Example 7-4 | | - | - | VAD | 3542 | 0.035 | 0.8 | SUS304 | 0.036 | 12 |
| Samples of the Invention | 9-1 | Si | 0.21 | RF-CVD | 2019 | 0.016 | 0.8 | SCM415 | 0.034 | 26 |
| | 9-2 | Ta | 0.48 | RF-CVD | 2832 | 0.045 | 0.9 | S45C | 0.029 | 20 |
| | 9-3 | TaC | 0.22 | RF-CVD | 8499 | 0.035 | 0.9 | SCM415 | 0.022 | 22 |
| | 9-4 | W | 0.13 | RF-CVD | 2979 | 0.036 | 0.7 | SCM415 | 0.036 | 24 |
| | 9-5 | W carbide | 0.76 | RF-CVD | 3508 | 0.06 | 0.6 | SKD11 | 0.021 | 25 |
| | 9-6 | Nb | 0.74 | RF-CVD | 3949 | 0.014 | 0.5 | FC250 | 0.023 | 24 |
| | 9-7 | Zr | 0.88 | RF-CVD | 2607 | 0.033 | 0.01 | SCM415 | 0.045 | 25 |
| | 9-8 | ZrC | 0.23 | RF-CVD | 1989 | 0.037 | 0.8 | AC8A | 0.037 | 25 |
| | 9-9 | TaC | 0.56 | RF-CVD | 4851 | 0.032 | 1 | SUS304 | 0.03 | 26 |
| | 9-10 | Hf | 0.58 | RF-CVD | 3499 | 0.068 | 1 | SCM415 | 0.03 | 28 |
| | 9-11 | Ta carbide | 0.43 | RF-CVD | 3278 | 0.056 | 0.3 | SCM415 | 0.033 | 23 |
| | 9-12 | Zr carbide | 0.33 | RP-CVD | 3361 | 0.007 | 0.8 | SKD11 | 0.033 | 24 |
| | *9-13 | Cr | 0.13 | RP-CVD | 4586 | 0.092 | 0.8 | SCM415 | 0.024 | 26 |
| | 9-14 | Si | 0.54 | VAD | 2401 | 0.007 | 0.6 | SCM415 | 0.082 | 26 |
| | 9-15 | Ta | 0.64 | VAD | 2185 | 0.006 | 1 | SCM415 | 0.042 | 22 |
| | *9-16 | W | 0.33 | VAD | 3940 | 0.124 | 0.8 | SUS304 | 0.037 | 24 |
| | 9-17 | Ti | 0.66 | VAD | 3175 | 0.03 | 0.7 | SKH51 | 0.036 | 25 |
| | 9-18 | Zr | 0.63 | VAD | 2773 | 0.009 | 0.6 | SUS304 | 0.04 | 23 |

(continued)

| | | Type of Intermediate Layer | Thickness of Intermediate Layer ($\mu$m) | Method of Film Formation | Knoop Hardness (kg/mm$^2$) | Surface Roughness ($\mu$m) | Film Thickness ($\mu$m) | Type of Substrate | Coefficient of Friction | Critical Peeling Load (N) |
|---|---|---|---|---|---|---|---|---|---|---|
| | 9-19 | ZrC | 0.54 | VAD | 6595 | 0.06 | 0.64 | SCM415 | 0.022 | 22 |
| | *9-20 | Cr | 0.12 | VAD | 3798 | 0.087 | 0.6 | SCM415 | 0.031 | 27 |
| | 9-21 | V | 0.63 | VAD | 2877 | 0.079 | 0.7 | AC8A | 0.035 | 21 |
| * Reference Example | | | | | | | | | | |

(Test Example 8)

Films were formed under the conditions as shown in Tables 11 and 12 by the similar methods of film formation as in Test Example 5. The method of measuring hardness and surface roughness were as described in Test Example 5. The Coefficient of friction was measured by a pin- on- disk tester. The conditions of testing were as follows: load weight was 10N, speed was 26 mm/s, total sliding distance was 290m, the counter material pin was made of SUJ2 having the diameter of 6 mm, and the coefficient of friction was measured in engine oil. The engine oil was SAE10W-40- SH, and the test temperature was room temperature. The amount of wear of the counterpart after the friction test was calculated based on the projection area of the wear trace on the pin.

Table 20 represents surface roughness Ra, coating hardness, types of substrates, film thickness and the coefficient of friction of coatings having surface roughness Ra exceeding 0.2 $\mu$m and the Knoop hardness between 2000 to 6000 kg/mm$^2$. As a comparative example, the coefficient of friction of an amorphous carbon film (Comparative Example 8-5) having Ra exceeding 0.2 $\mu$m and Knoop hardness of 1738 kg/mm$^2$ was measured. When compared with Comparative Example 8-5, the coefficient of friction was reduced. Namely, the coating having the hardness of 2000 to 6000 kg/mm$^2$ is effective to reduce the coefficient of friction.

Table 20

| | | Method of Film Formation | Knoop Hardness (kg/mm$^2$) | Surface Roughness Ra ($\mu$m) | Film Thickness ($\mu$m) | Type of Substrate | Coefficient of Friction |
|---|---|---|---|---|---|---|---|
| Comparative Example 8-5 | | VAD | 1738 | 0.26 | 1.1 | SUS304 | 0.07 |
| * Samples | 10-1 | RF-CVD | 4563 | 0.250 | 0.9 | SUS304 | 0.042 |
| | 10-2 | VAD | 3655 | 0.225 | 0.63 | SCM415 | 0.045 |
| | 10-5 | VAD | 2684 | 0.233 | 0.45 | SKD51 | 0.048 |
| | 10-4 | VAD | 5867 | 0.246 | 1.65 | S45C | 0.042 |
| * Reference Examples | | | | | | | |

Table 21 represents surface roughness Ra, coating hardness, types of substrates, film thickness and the Coefficient of friction of the coatings having Knoop hardness of 2000 to 6000 kg/mm$^2$ and Ra of 0.005 to 0.2 $\mu$m.

Table 21

| | | Method of Film Formation | Knoop Hardness (kg/mm$^2$) | Surface Roughness Ra ($\mu$m) | Film Thickness ($\mu$m) | Type of Substrate | Coefficient of Friction |
|---|---|---|---|---|---|---|---|
| Comparative Example 8-5 | | VAD | 1738 | 0.26 | 1.1 | SUS304 | 0.07 |
| Samples of the Invention | *11.1 | RF-CVD | 3587 | 0.165 | 1.79 | SUS304 | 0.088 |
| | 11-2 | RF-CVD | 4567 | 0.070 | 2.65 | S45C | 0.036 |
| | 11-3 | RF-CVD | 4123 | 0.007 | 1.02 | SCM415 | 0.026 |
| | *11-4 | RF-CVD | 2568 | 0.176 | 0.86 | FC250 | 0.037 |
| | *11-5 | RF-CVD | 2236 | 0.093 | 0.53 | SCM415 | 0.036 |
| | 11-6 | RF-CVD | 3235 | 0.065 | 0.46 | S45C | 0.032 |
| | *11-7 | RF-CVD | 2243 | 0.122 | 0.44 | SKD51 | 0.046 |
| | *11-8 | VAD | 2689 | 0.096 | 0.3 | SUS304 | 0.035 |
| | 11-9 | VAD | 3987 | 0.065 | 1.95 | SCr415 | 0.032 |
| | 11-10 | VAD | 4359 | 0.042 | 1.65 | AC8A | 0.028 |

(continued)

| | | Method of Film Formation | Knoop Hardness (kg/mm$^2$) | Surface Roughness Ra ($\mu$m) | Film Thickness ($\mu$m) | Type of Substrate | Coefficient of Friction |
|---|---|---|---|---|---|---|---|
| | 11-11 | VAD | 3657 | 0.078 | 0.78 | SHD11 | 0.03 |
| | *11-12 | VAD | 2697 | 0.165 | 0.66 | FC250 | 0.038 |
| | 11-13 | VAD | 4867 | 0.086 | 0.35 | SKD51 | 0.029 |
| | *11-14 | VAD | 2374 | 0.146 | 0.22 | SUS304 | 0.046 |
| | 11-15 | VAD | 5682 | 0.032 | 1.88 | SCr415 | 0.026 |
| | 11-16 | VAD | 3668 | 0.01 | 2.67 | SCM415 | 0.031 |
| * Reference Examples | | | | | | | |

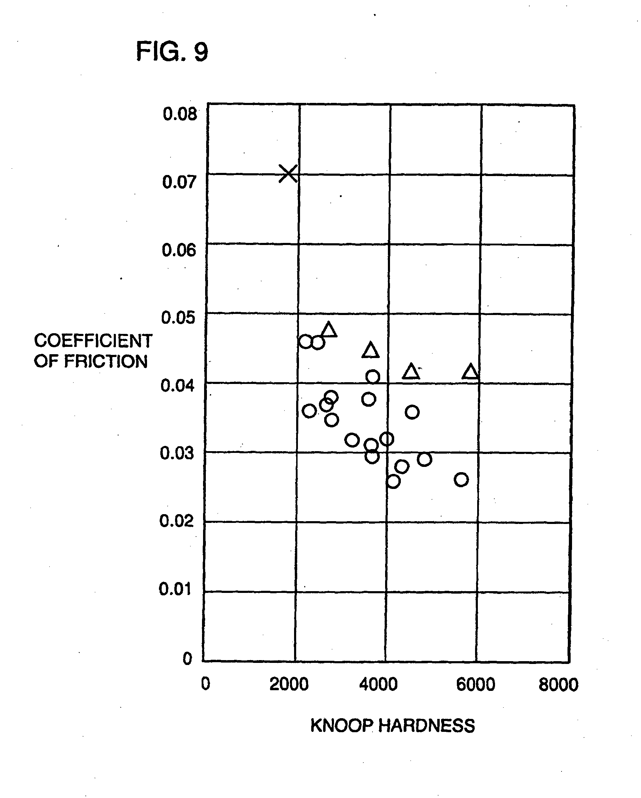

Fig. 9 shows the relation between the hardness and the coefficient of friction. Comparative Example 8-5 of Table 20 is represented by the sign ×, the coating having surface roughness Ra exceeding 0.2 $\mu$m is represented by $\Delta$, and the coating having surface roughness Ra of 0.005 to 0.2 $\mu$m is represented by $\bigcirc$. The Coefficient of friction is the lowest when the Knoop hardness is 2000 to 6000 kg/mm$^2$ and Ra is within the range of 0.005 to 0.2 $\mu$m.

Table 22 represents the amount of wear of the counterpart pin is made of SUJ2 relative to the samplers shown in Table 21. The amount of wear is a projection area of the worn portion of the pin viewed from the direction of pushing load. A value of the wear amount of the counterpart of each coating standardized by the amount of wear of the counterpart made of TiN (hardness 1748 kg/mm$^2$, Ra = 0.113 $\mu$m), that is, the value (wear amount ratio = amount of wear of the counterpart for each coatings/amount of wear of the counterpart made of TiN (hardness 1748 kg/mm$^2$, Ra = 0.113$\mu$ m)) is also shown in Table 22.

Table 22

| | | Method of Film Formation | Knoop Hardness (kg/mm$^2$) | Surface Roughness Ra ($\mu$m) | Hardness x Ra | Area of Wear Trace (mm$^2$) | Ratiob of Wear Amount |
|---|---|---|---|---|---|---|---|
| TiN | | VAD | 1748 | 0.113 | 197 | 0.45 | 1 |
| TiN | | VAD | 2437 | 0.196 | 477 | 0.678 | 1.50 |
| TiN | | VAD | 2265 | 0.152 | 344 | 0.586 | 1.30 |
| Samples of the Invention | *12-1 | RF-CVD | 3587 | 0.165 | 591 | 0.476 | 1.06 |
| | 12-2 | RF-CVD | 4567 | 0.070 | 319 | 0.398 | 0.88 |
| | 12-5 | RF-CVD | 4123 | 0.007 | 28 | 0.144 | 0.32 |
| | *12-4 | RF-CVD | 2568 | 0.176 | 451 | 0.435 | 0.97 |
| | *12-5 | RF-CVD | 2236 | 0.093 | 207 | 0.316 | 0.70 |
| | 12-6 | RF-CVD | 3235 | 0.065 | 210 | 0.344 | 0.76 |
| | *12-7 | RF-CVD | 2243 | 0.122 | 273 | 0.374 | 0.83 |
| | *12-8 | VAD | 2689 | 0.096 | 258 | 0.31 | 0.69 |
| | 12-9 | VAD | 3987 | 0.065 | 259 | 0.335 | 0.74 |
| | 12-10 | VAD | 4359 | 0.042 | 183 | 0.304 | 0.68 |
| | 12-11 | VAD | 3657 | 0.078 | 285 | 0.366 | 0.81 |
| | *12-12 | VAD | 2697 | 0.165 | 445 | 0.426 | 0.95 |
| | 12-13 | VAD | 4867 | 0.086 | 418 | 0.401 | 0.89 |

(continued)

| | | Method of Film Formation | Knoop Hardness (kg/mm$^2$) | Surface Roughness Ra ($\mu$m) | Hardness x Ra | Area of Wear Trace (mm$^2$) | Ratiob of Wear Amount |
|---|---|---|---|---|---|---|---|
| | *12-14 | VAD | 2374 | 0.146 | 346 | 0.405 | 0.9 |
| | 12-15 | VAD | 5682 | 0.032 | 181 | 0.267 | 0.59 |
| | 12-16 | VAD | 3668 | 0.01 | 36 | 0.223 | 0.50 |
| * Reference Examples | | | | | | | |

Fog. 10 represents the relation between the wear amount ratio and Ra ($\mu$m) $\times$ Hk (kg/mm$^2$). As a result, it was found that the ratio of wear amount of the amorphous carbon film was in proportion to Ra ($\mu$m) $\times$ Hk (kg/mm$^2$). Even when the value of Ra ($\mu$m) $\times$ Hk (kg/mm$^2$) was the same, the attacking of the counterpart of the amorphous carbon film was not so severe as compared with TiN film. In order that the amorphous carbon film has lower attacking property than other nitride, the value Ra ($\mu$m) $\times$ Hk (kg/mm$^2$) should be at most 500. Therefore, when lower attacking property as well as low coefficient of friction are to be attained, a coating is desirable which satisfies the value A of not higher than 500, where the value A is Ra ($\mu$m) $\times$ Hk (kg/mm$^2$) = A.

(Test Example 9)

Intermediate layers were formed by the similar methods and similar conditions as in Test Example 6. Thereafter, amorphous carbon coatings were formed by RF plasma CVD or vacuum arc discharge deposition. The method of film formations and conditions of film formation of RF excited plasma CVD and vacuum are discharge deposition are similar to those of Test Example 5.

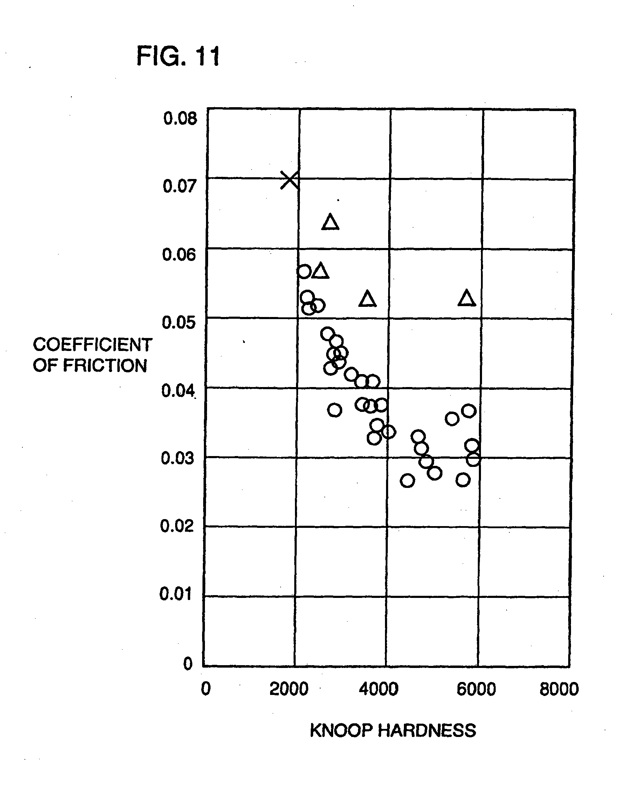

The measurement of the coefficient of friction was conducted under the same conditions as the pin-on-disk test of Test Example 5. Tables 23 and 24 represent intermediate layers, thickness of intermediate layers, surface roughness, coating hardness, types of substrates, film thickness and the coefficient of friction. Fig. 11 shows the relation between the hardness and the coefficient of friction. In the graph, Comparative Example 8-5 of Table 20 is represented by $\times$, the coating have the surface roughness Ra exceeding 0.2 $\mu$m is represented by A, and the coating having surface roughness Ra is between 0.005 to 0.2 $\mu$m is represented by $\bigcirc$. The coefficient of friction is the lowest when the Knoop hardness is within the range of 2000 to 6000 kg/mm$^2$ and Ra is in the range of 0.005 to 0.2 $\mu$m. The results are similar to those obtained in Test Example 8, and therefore it was found that introduction of the intermediate layer does not have any undesirable influence on the coefficient of friction.

Table 23

| | | Type of Intermediate Layer | Thickness of Intermediate Layer ($\mu$m) | Method of Film Formation | Knoop Hardness (kg/mm$^2$) | Surface Roughness Ra ($\mu$m) | Film Thiakness ($\mu$m) | Type of Substrate | Coefficient of Friction |
|---|---|---|---|---|---|---|---|---|---|
| Comparative Example 8-5 | | - | - | VAD | 1738 | 0.26 | 1.1 | SUS304 | 0.07 |
| Samples of the Invention | *13-1 | Si | 0.35 | RF-CVD | 2467 | 0.25 | 1.64 | SUS304 | 0.057 |
| | *13-2 | Ti | 0.26 | RF-CVD | 5784 | 0.37 | 0.57 | SCM415 | 0.053 |
| | *13-3 | Tn | 0.44 | RF-CVD | 2673 | 0.48 | 0.88 | S45C | 0.064 |
| | *13-4 | W | 0.36 | RF-CVD | 3614 | 0.35 | 0.93 | FC250 | 0.053 |
| | *13-5 | Cr | 0.21 | RF-CVD | 3577 | 0.32 | 0.84 | SCM415 | 0.051 |
| | *13-6 | Ti | 0.53 | RF-CVD | 2643 | 0.193 | 1.02 | SKD11 | 0.043 |
| | 13-7 | Cr | 0.23 | RF-CVD | 3644 | 0.067 | 0.87 | SCM415 | 0.063 |
| | 13-8 | V | 0.57 | RF-CVD | 2141 | 0.045 | 0.94 | SKH51 | 0.061 |
| | *13-9 | Ta | 0.67 | RF-CVD | 2765 | 0.164 | 0.74 | SCM415 | 0.037 |
| | 13-10 | Zr | 0.12 | RF-CVD | 3856 | 0.034 | 0.36 | SUSS04 | 0.038 |
| | 13-11 | Ta | 0.7 | RF-CVD | 4675 | 0.056 | 1.86 | S45C | 0.032 |
| | 13-12 | TaC | 0.86 | RF-CVD | 4387 | 0.078 | 0.98 | SCr436 | 0.027 |
| | *13-13 | Si | 0.88 | RF-CVD | 3678 | 0.097 | 0.78 | SKH51 | 0.033 |
| | 13-14 | Si | 0.53 | RF-CVD | 5748 | 0.009 | 0.77 | SUS304 | 0.037 |
| | 13-15 | W carbide | 0.89 | RF-CVD | 2764 | 0.057 | 1.06 | SCM415 | 0.047 |
| | *13-16 | Nb | 0.44 | RF-CVD | 2846 | 0.137 | 1.13 | SCr436 | 0.045 |
| | *13-17 | Hf | 0.87 | RF-CVD | 2235 | 0.168 | 1.04 | S45C | 0.052 |
| | 13-18 | W | 0.59 | RF-CVD | 3387 | 0.045 | 0.98 | SCM415 | 0.038 |
| | 13-19 | Nb | 0.35 | RF-CVD | 3984 | 0.069 | 0.96 | SCM415 | 0.034 |
| | 13-20 | TaC | 0.61 | RF-CVD | 4725 | 0.082 | 0.54 | AC8A | 0.03 |
| * Reference Examples | | | | | | | | | |

Table 24

| | | Type of Intermediate Layer | Thicknese of Intermediate Layer ($\mu$m) | Method of Film Formation | Knoop Hardnees kg/mm$^2$) | Surface Roughness Ra ($\mu$m) | Film Thickness ($\mu$m) | Type of Substrate | Coeffcient of Friction |
|---|---|---|---|---|---|---|---|---|---|
| Comparative Example 8-5 | | - | - | VAD | 1738 | 0.26 | 1.1 | SUS304 | 0.07 |
| Samples of the Invention | *13-21 | Hf carbide | 0.26 | RF-CVD | 4631 | 0.196 | 0.26 | SKD11 | 0.033 |
| | *13-22 | Ta carbide | 0.49 | RF-CVD | 2137 | 0.164 | 0.79 | SUS304 | 0.057 |
| | 13-23 | Zr carbide | 0.85 | RF-CVD | 3374 | 0.024 | 1.66 | S45C | 0.041 |
| | 18-24 | Ti | 0.77 | VAD | 3584 | 0.066 | L87 | SCM416 | 0.038 |
| | 18-25 | Ti | 0.47 | VAD | 5872 | 0.072 | 0.31 | SKD11 | 0.032 |
| | 13-26 | Cr | 0.15 | VAD | 4235 | 0.084 | 0.67 | SCM415 | 0.031 |
| | *13-27 | Cr carbide | 0.12 | VAD | 8798 | 0.097 | 0.77 | SCM415 | 0.034 |
| | *13-28 | V | 0.43 | VAD | 2868 | 0.115 | 0.88 | SKD11 | 0.037 |
| | 13-29 | Si | 0.26 | VAD | 5362 | 0.041 | 1.11 | SUS304 | 0.036 |
| | 13-30 | Si | 0.59 | VAD | 8124 | 0.036 | 1.68 | SCr436 | 0.042 |
| | *13-31 | Si | 0.74 | VAD | 2174 | 0.157 | 0.54 | FC260 | 0.053 |
| | 13-32 | Nb | 0.68 | VAD | 2586 | 0.007 | 0.24 | SUS304 | 0.048 |
| | *13-33 | Nb | 0.66 | VAD | 3647 | 0.125 | 0.13 | SCM415 | 0.041 |
| | 13-34 | W | 0.53 | VAD | 4768 | 0.058 | 0.88 | SKD11 | 0.03 |
| | 13-35 | W | 0.31 | VAD | 4986 | 0.074 | 1.36 | SCM415 | 0.028 |
| | 13.36* | Zr | 0.24 | VAD | 5634 | 0.062 | 1.87 | S46C | 0.027 |
| | 13-37 | Zr | 0.51 | VAD | 2764 | 0.033 | 0.63 | SUS304 | 0.045 |
| | 13-38 | Hf | 0.84 | VAD | 5896 | 0.048 | 0.67 | SCr436 | 0.03 |
| | *13-39 | W carbide | 0.53 | VAD | 2343 | 0.135 | 1.38 | AC8A | 0.052 |
| | *13-40 | Nb carbide | 0.59 | VAD | 2854 | 0.164 | 0.74 | SCM415 | 0.044 |

(continued)

| | Type of Intermediate Layer | Thicknese of Intermediate Layer (μm) | Method of Film Formation | Knoop Hardnees kg/mm² | Surface Roughness Ra (μm) | Film Thickness (μm) | Type of Substrate | Coeffcient of Friction |
|---|---|---|---|---|---|---|---|---|
| 13-41 | Ti carbide | 0.74 | VAD | 8763 | 0.074 | 0.89 | SKH51 | 0.035 |

*Reference Examples

(Test Example 10)

Scratch test was performed in the similar manner as in Test Example 7, and adhesion between the substrate and the coating was studied. The method and conditions of the test were the same as in Test Example 7. The results are as shown in Tables 25 and 26. A comparative example is an amorphous carbon film directly formed on the substrate without any intermediate layer. It was found that by the introduction of the intermediate layer, the adhesion was increased.

Table 25

| | Type of Intermediate Layer | Thickness of Intermediate Layer (μm) | Method of Film Formation | Knoop Hardness (kg/mm²) | Surface Roughness Ra (μm) | Film Thickness (μm) | Type of Substrate | Coefficient of Friction | Critical Peeling Load (N) |
|---|---|---|---|---|---|---|---|---|---|
| Comparative Example 7-3 | - | - | RF-CVD | 2564 | 0.045 | 0.8 | S45C | 0.034 | 15 |
| Comparative Example 7-4 | - | - | VAD | 3542 | 0.035 | 0.8 | SUS304 | 0.036 | 12 |
| *14-1 | Ti | 0.53 | RF-CVD | 2643 | 0.193 | 1.02 | SKD11 | 0.043 | 28 |
| 14-2 | Zr | 0.12 | RF-CVD | 3856 | 0.034 | 0.36 | SUS304 | 0.038 | 26 |
| 14-3 | Ta | 0.7 | RF-CVD | 4675 | 0.056 | 1.86 | S45C | 0.032 | 25 |
| 14-4 | Si | 0.53 | RF-CVD | 5748 | 0.009 | 0.77 | SUS304 | 0.037 | 24 |
| 14-5 | W carbide | 0.89 | RF-CVD | 2764 | 0.057 | 1.06 | SCM415 | 0.047 | 27 |
| *14-6 | Hf | 0.87 | RF-CVD | 2235 | 0.168 | 1.04 | S45C | 0.052 | 29 |
| 14-7 (Samples of the Invention) | W | 0.59 | RF-CVD | 3387 | 0.045 | 0.98 | SCM415 | 0.038 | 27 |
| 14-8 | Nb | 0.35 | RF-CVD | 3984 | 0.069 | 0.96 | SCM415 | 0.034 | 26 |
| 14-9 | TaC | 0.61 | RF-CVD | 4725 | 0.082 | 0.54 | AC8A | 0.03 | 24 |
| *14-10 | Hf carbide | 0.26 | RF-CVD | 4631 | 0.196 | 0.26 | SKD11 | 0.033 | 25 |
| *14-11 | Ta carbide | 0.49 | RF-CVD | 2137 | 0.164 | 0.79 | SUS304 | 0.057 | 25 |
| 14.12 | Zr carbide | 0.85 | RF-CVD | 3374 | 0.024 | 1.66 | S45C | 0.041 | 25 |
| 14-13 | Cr | 0.23 | RF-CVD | 3644 | 0.067 | 0.87 | SCM415 | 0.063 | 29 |
| 14-14 | V | 0.57 | RF-CVD | 2141 | 0.045 | 0.94 | SKH51 | 0.061 | 25 |

*Reference Examples

Table 26

| | Type of Intermediate Layer | Thickness of Intermediate Layer (µm) | Method of Film Formation | Knoop Hardness (kg/mm²) | Surface Roughness Ra (µm) | Film Thickness (µm) | Type of substrate | Coefficient of Friction | Critical Peeling Load (N) |
|---|---|---|---|---|---|---|---|---|---|
| Comparative Example 7-3 | - | - | RF-CVD | 2564 | 0.045 | 0.8 | S45C | 0.034 | 15 |
| Comparative Example 7-4 | - | - | VAD | 3542 | 0.036 | 0.8 | SUS304 | 0.036 | 12 |
| 14-15 | Ti | 0.77 | VAD | 3584 | 0.066 | 1.87 | SCM415 | 0.038 | 28 |
| 14-16 | Si | 0.26 | VAD | 5362 | 0.041 | 1.37 | SUS304 | 0.036 | 30 |
| *14-17 | Nb | 0.66 | VAD | 3647 | 0.125 | 0.13 | SCM415 | 0.041 | 26 |
| 14-18 | W | 0.53 | VAD | 4768 | 0.053 | 0.88 | SKD11 | 0.03 | 27 |
| 14-19 | Zr | 0.51 | VAD | 2764 | 0.033 | 0.68 | SUS304 | 0.045 | 28 |
| 14-20 | Hf | 0.84 | VAD | 5896 | 0.048 | 0.67 | SCr436 | 0.03 | 23 |
| 14-21 | Cr | 0.15 | VAD | 4235 | 0.084 | 0.67 | SCM415 | 0.031 | 28 |
| *14-22 | Cr carbide | 0.12 | VAD | 3798 | 0.097 | 0.77 | SCM415 | 0.034 | 27 |
| *14-23 | V | 0.43 | VAD | 2858 | 0.115 | 0.88 | SKD11 | 0.037 | 24 |
| *14-24 | W carbide | 0.53 | VAD | 2343 | 0.135 | 1.38 | AC8A | 0.052 | 25 |
| *14-25 | Nb carbide | 0.59 | VAD | 2854 | 0.164 | 0.74 | SCM415 | 0.044 | 26 |
| 14-26 | Ti carbide | 0.74 | VAD | 3763 | 0.074 | 0.89 | SKH51 | 0.035 | 24 |

Samples of the Invention (14-15 to 14-26)

*Reference Examples

(Test Example 11)

The samples of coatings were each formed on a cam as an engine part, and the torque was measured by motoring test. By the motoring test of Examples 5-3, 6-2, 6-6, 7-5, 7-16, 8-14 and 8-38, reduction in torque by 10 to 30% from Comparative Example 5-1 was confirmed.

(Test Example 12)

Films were formed by RF magnetron sputtering (SP), unbalanced magnetron sputtering (UBM), vacuum arc discharge deposition (VAD) and hot filament CVD (HCVD). Iron based alloys such as high speed tool steel, stainless steel and SKD, aluminum alloy and iron based sintered body were used as the substrates. In order to clean the surface of the substrate, ultrasonic cleaning of at least 10 minutes was performed in acetone.

In film formation according to RF magnetron sputtering, a solid carbon target was used, and the film was formed in Ar gas atmosphere. An RF power could be applied to a target and to the substrate holder. In the embodiment, hard carbon coatings having arbitrary Raman spectral profiles could be formed by changing various conditions, provided that the bias to be applied to the substrate was at most 150W, atmospheric pressure was at most 4Pa and the substrate temperature was at most 873K.

In unbalanced magnetron sputtering method, a solid carbon target was used as the raw material, an argon gas to which 0 to 50% of $CH_4$, $C_6H_6$ or $C_2H_2$ was added to the atmosphere, pulsed DC was applied to the target, and pulsed or non-pulsed DC applied to the substrate. In the embodiment, hard carbon coatings having arbitrary Raman spectral profiles could be formed by changing various conditions provided that the bias to be applied to the substrate was at most 600V, atmospheric pressure was at most 4Pa, and substrate temperature was at most 873K, with the amount of $CH_4$, $C_6H_6$ or $C_2H_2$ varied.

In vacuum arc discharge deposition also, a solid carbon target was used for film formation. Inert gas atmosphere such as Ar or in vacuum, a cathode arc discharge was generated on the surface of the carbon target, so that carbon was evaporated. The evaporated carbon was turned to ions and activated by arc plasma, and reached the substrate which was negative, whereby the hard carbon film was deposited. In the embodiment, hard carbon coatings having arbitrary Raman spectral profiles could be formed by changing various conditions provided that the atmospheric pressure was at most 4Pa, substrate temperature was at most 873K and the voltage applied to the substrate was at most 300V.

In film formation by hot filament CVD, a gas selected from $CH_4$, $C_6H_6$ and $C_2H_2$ was used as the raw material, and the film was formed in hydrogen atmosphere. By changing the atmospheric pressure, distance between the filament and the substrate and the amount of $CH_4$, $C_6H_6$ or $C_2H_2$, hard carbon coatings having arbitrary Raman spectral profiles could be formed. The embodiment could be implemented by setting the amount of $CH_4$, $C_6H_6$ or $C_2H_2$ to be at most 50 vol%.

By the above described methods, hard carbon films of different thicknesses were formed. Raman scattering spectroscopy was performed on the resulting coatings, using an argon ion laser having the wavelength of 514.5 nm. The background of the resulting spectrum was removed and the waveforms were separated by Gaussian function so that peak intensity and peak integration intensity were calculated. The peaks could be classified into three peaks, that is, one between $500cm^{-1}$ to $1000cm^{-1}$, one around $1340cm^{-1}$ and one around $1560cm^{-1}$.

Friction wear test in accordance with the pin-on-disk method was performed on the resulting hard carbon films. The atmosphere was lubrication by dropping gasoline, light oil and engine oil SAE10W-30SG. The hard carbon film was used as the disk, the counterpart material was a pin formed of SUJ2 having the tip end radius of curvature R of 3 mm, load was 10N, the speed of rotation was 250rpm (sliding speed 50 mm/sec) and the number of rotation was 50,000. The coefficient of friction was measured after the end of sliding test of 50,000 times, and after the sliding test, the shape of the disk wear trace was measured by a surface roughness gauge, and the wear cross section was calculated based on the geometrical shape. The wear amount of each coating was as shown in the table, where the amount of wear of Comparative Example 12-4 was set to 1. The thickness and hydrogen content of the hard carbon films were also measured. The results are as shown in Tables 27 and 28.

Table 27

| | | I600/ I1340 | S600/ S1340 | S1340/ S1560 | I1340/ I1560 | Peak Position of SP3 Peak (cm-1) | Film Thickness (μm) | Substrate | Lubricant | Method of Film Formation | Coeficient of Friction | Amount of Wear | Hydrogen content (at%) |
|---|---|---|---|---|---|---|---|---|---|---|---|---|---|
| Comparative Example | 12-1 | 0.015 | 0.006 | 5.1 | 1.8 | 1552 | 2.2 | Si₃N₄ | engine oil | SP | 0.06 | 0.7 | 22 |
| | 12-2 | 0.01 | 0.007 | 4.5 | 1.6 | 1556 | 9.8 | Al₂O₃ | engine oil | HCVD | 0.06 | 0.7 | 35 |
| | 12-3 | 0.001 | 0.001 | 5.5 | 2.2 | 1552 | 1.5 | SCM415 | light oil | VAD | 0.08 | 0.9 | 28 |
| | 12-4 | 0 | 0 | 6 | 2.5 | 1549 | 0.7 | SUS304 | gasoline | UBM | 0.07 | 1 | 23 |
| Invention | 12-1 | 0.03 | | | | | 0.5 | S45c | gasoline | SP | 0.06 | 0.5 | 0 |
| | *12-2 | 0.4 | | | | | 0.2 | SKH51 | engine oil | UBM | 0.05 | 0.5 | 15 |
| | 12-3 | 1-5 | | | | | 0.8 | FC450 | engine oil | SP | 0.04 | 0.4 | 0 |
| | 12-4 | 2.2 | | | | | 1.2 | SCM415 | engine oil | VAD | 0.04 | 0.4 | 0 |
| | *12-5 | | 0.02 | | | | 1 | SKD11 | engine oil | UBM | 0.05 | 0.5 | 11 |
| | *12-6 | | 0.1 | | | | 1.4 | S450 | light oil | HCVD | 0.06 | 0.4 | 18 |
| | 12-7 | | 1.2 | | | | 1.2 | SUS304 | engine oil | SP | 0.04 | 0.4 | 0 |
| | 12-8 | | 2.4 | | | | 2.4 | SCM415 | engine oil | VAD | 0.04 | 0.3 | 0 |
| | *12-9 | | | 2.8 | | | 6.8 | Si₃N₄ | engine oil | HCVD | 0.03 | 0.6 | 10 |
| | 12-10 | | | 0.1 | | | 8.1 | SUS304 | engine oil | VAD | 0.03 | 0.4 | 0 |
| | *12-11 | | | 1.2 | | | 0.8 | SCM415 | engine oil | UBM | 0.04 | 0.4 | 10 |
| | 12-12 | | | 2.4 | | | 0.9 | Al₂O₃ | engine oil | SP | 0.05 | 0.3 | 0 |
| | 12-13 | | | | 1.1 | | 0.7 | SUS304 | engine oil | UBM | 0.03 | 0.5 | 4 |
| | 12-14 | | | | 0.7 | | 0.4 | SKH51 | engine oil | SP | 0.04 | 0.4 | 0 |

*Reference Example

Table 28

| | I600/ I1340 | S600/ S1340 | S1340/ S1660 | I1340/ I1660 | Peak Position of SP³ Peak (cm⁻¹) | Film Thickness (µm) | Substrate | Lubricant | Method of Film formation | Coefficient of Friction | Amount of Wear | Hydrogen Content (at%) |
|---|---|---|---|---|---|---|---|---|---|---|---|---|
| 12-15 | | | | 0.5 | | 1 | SCM415 | engine oil | VAD | 0.05 | 0.3 | 0 |
| 12-16 | | | | 0.12 | | 1.3 | FC450 | light oil | SP | 0.06 | 0.7 | 0 |
| *12-17 | | | | | 1564 | 0.1 | SUS304 | engine oil | UBM | 0.05 | 0.4 | 11 |
| 12-18 | | | | | 1568 | 1.2 | SCM415 | gasoline | SP | 0.05 | 0.4 | 0 |
| 12-19 | | | | | 1572 | 6.6 | FC450 | engine oil | VAD | 0.04 | 0.3 | 0 |
| 12-20 | | | | | 1578 | 7.6 | SUS304 | engine oil | VAD | 0.04 | 0.8 | 0 |
| *12-21 | 0.2 | | 2.9 | | | 1 | SKH51 | light oil | HCVD | 0.05 | 0.8 | 19 |
| 12-22 | 2 | | 0.3 | | | 0.8 | SUS304 | engine oil | SP | 0.08 | 0.3 | 0 |
| 12-23 | | 0.01 | 2.7 | | | 0.6 | S45c | engine oil | SP | 0.03 | 0.4 | 0 |
| 12-24 | | 2.5 | 0.45 | | | 0.9 | SCM415 | engine oil | VAD | 0.04 | 0.3 | 0 |
| 12-25 | 0.1 | | | 1 | | 1 | SKD51 | engine oil | UBM | 0.05 | 0.4 | 4 |
| 12-26 | 2.4 | | | 0.11 | | 1.2 | FC450 | gasoline | SP | 0.04 | 0.9 | 0 |
| 12-27 | | 0.05 | | 0.8 | | 1.5 | S45o | engine oil | UBM | 0.03 | 0.4 | 0 |
| 12-28 | | 2.5 | | 0.3 | | 1.8 | AC8A | engine oil | SP | 0.04 | 0.3 | 0 |
| 12-29 | 0.8 | | 1.2 | | 1564 | 2 | SUS304 | gasoline | UBM | 0.04 | 0.8 | 0 |
| 12-30 | 0.4 | | | 1.1 | 1568 | 1 | SKD11 | light oil | SP | 0.04 | 0.6 | 0 |
| 12-31 | | 2.1 | 0.4 | | 1572 | 0.8 | SCM415 | engine oil | VAD | 0.03 | 0.3 | 0 |
| 12-32 | | 2.2 | | 0.6 | 1578 | 0.4 | SKH51 | engine oil | SP | 0.02 | 0.3 | 0 |

Invention

*Reference Example

(Test Example 13)

Hard carbon coatings in accordance with Examples 12-2, 4, 8, 10, 16, 20, 22, 23, 25, 27, 29 and 31 were each formed on an outer periphery of a shaft of $\phi$8 mm. Thereafter, the resulting shaft was combined with a bearing of silicon nitride or $Al_2O_3$, and used under lubrication by dropping engine oil SAE10W-30SG. The life until breakage and the wear amount were improved by 1.5 to 4 times than the carbon coatings in accordance with Comparative Examples 12-1 to 12-4.

(Test Example 14)

The hard carbon films in accordance with Examples 12-2, 4, 8, 10, 16, 20, 22, 23, 25, 27, 29 and 31 were each formed on a piston skirt portion of an engine formed of aluminum alloy AC8A, and used under lubrication by dropping engine oil SAE10W-30SG. Wear resistances were measured, and the coefficient of friction was reduced by 20 to 80% as compared with Comparative Examples 12-1 to 12-4.

(Test Example 15)

Hard carbon coatings in accordance with Examples 12-3, 7, 11, 16, 20, 21, 24, 26, 28 and 30 were each formed on a surface of a valve shim, and used under lubrication by dropping engine oil SAE10W-30SG and the cam torque was measured. The torque was reduced by about 15 to 60% than the parts on which coatings in accordance with Comparative Examples 12-1 to 4 were formed.

(Test Example 16)

Hard coatings were formed on the substrates in accordance with the same method as Test Example 12, and the coefficient of friction and the amount of wear were measured by the similar test. The wear amount was standardized using the wear amount of Comparative Example 16-1 as 1. Densities of the resulting hard coatings were also measured. The density was calculated by dividing the change in weight of the sample, substrate and film, before and after film formation by deposition volume. The conditions and results are as shown in Table 29.

Table 29

| | | Density (g/cm³) | Film Thickness (μm) | Substrate | Lubricant | Method of Film Formation | Coefficient of Friction | Amount of Wear |
|---|---|---|---|---|---|---|---|---|
| Comparative Example | 16-1 | 2.4 | 1.5 | SCM415 | engine oil | SP | 0.06 | 0.7 |
| | | | | | gasoline | | 0.08 | 0.9 |
| | | | | | light oil | | 0.09 | 1 |
| Invention | 16-1 | 2.7 | 3 | SCM415 | engine oil | SP | 0.05 | 0.6 |
| | 16-2 | 3.0 | 1.2 | SKH51 | gasoline | VAD | 0.06 | 0.7 |
| | 16-3 | 3.2 | 1.3 | $Si_3N_4$ | engine oil | UBM | 0.03 | 0.2 |
| | 16-4 | 3.5 | 0.6 | SCM415 | engine oil | VAD | 0.04 | 0.3 |
| | 16-5 | 2.6 | 0.4 | SUS304 | light oil | SP | 0.06 | 0.7 |
| | 16-6 | 2.8 | 6.7 | S45c | engine oil | HCVD | 0.05 | 0.6 |
| | 16-7 | 3.4 | 3.2 | SKD11 | engine oil | VAD | 0.04 | 0.5 |
| | 16-8 | 3.3 | 0.8 | AC8A | engine oil | SP | 0.05 | 0.6 |
| | 16-9 | 3.2 | 9.8 | SKH51 | engine oil | HCVD | 0.04 | 0.3 |
| | 16-10 | 3.2 | 0.1 | FC450 | engine oil | UBM | 0.05 | 0.5 |

As can be seen from the table 29, the examples of the present invention having the density of at least 2.6 g/cm³ have smaller coefficient of friction as compared with Comparative Example 16-1, and the amount of wear is also smaller.

(Test Example 17)

Hard coatings were formed on the substrates in the similar methods of film formation as Test Example 12, and the coefficient of friction and the amount of wear were measured by the similar tests. The amount of wear was standardized using the amount of wear of Comparative Example 17-1 as 1. Further, the amount of carbon component having $SP^2$ bond of the resulting hard coatings was also calculated. The amount of carbon component was calculated by standardizing peak intensity derived from $SP^2$ bonded carbon in the sample spectrum in accordance with EELS by using peak intensity of graphite ($SP^2$ ratio is 100 at.%). Conditions and results of the test are as shown in Table 30.

Table 30

| | | $SP_2$ Bonding Ratio (at.%) | Film Thickness ($\mu$m) | Substrate | Lubricant | Method of Film Formation | Coefficient of Friction | Amount of Wear |
|---|---|---|---|---|---|---|---|---|
| Comparative Example | 17-1 | 50 | 1.5 | SUS304 | engine oil | SP | 0.06 | 1 |
| Invention | 17-1 | 20 | 6.5 | SCM415 | engine oil | SP | 0.04 | 0.6 |
| | 17-2 | 15 | 0.5 | SUS304 | engine oil | VAD | 0.04 | 0.7 |
| | 17-3 | 25 | 0.1 | $Si_3N_4$ | engine oil | UBM | 0.03 | 0.2 |
| | 17-4 | 10 | 1.2 | SKH51 | engine oil | HCVD | 0.04 | 0.3 |
| | 17-5 | 5 | 2.5 | FC450 | engine oil | UBM | 0.05 | 0.5 |

As can be seen from table 30, examples of which carbon component having $SP^2$ bond was within the range of 1 to 40 at.% had smaller coefficient of friction and smaller wear amount than Comparative Example 17-1.
Although the present invention has been described and illustrated in detail, it is clearly understood that the same is by way of illustration and example only and is not to be taken by way of limitation, the scope of the present invention being limited only by the terms of the appended claims.

**Claims**

1. A coated member comprising:

   a substrate,
   a hard coating arranged directly or via an intermediate layer on at least a part of the substrate, and
   a lubricant in contact with said hard coating;
   wherein:
   said hard coating is amorphous and consists of carbon, unavoidable impurities and optionally hydrogen in an amount of 5 atomic % or less;
   said hard coating has an average Knoop hardness (Hk) of 1800 kg/mm$^2$ to 8000 kg/mm$^2$, measured by the indentation fracture method using a Knoop indentator of diamond, a load of 50 g and a time of applying the load of 10 seconds, the average value of ten measurements points being taken; and
   said hard coating has a central line average surface roughness Ra of at least 0.005 $\mu$m and at most 0.086$\mu$m; and the multiplication product (A) of said average Knoop hardness times said surface roughness is at most 300 (Ra x Hk = A $\leq$ 300),
   **characterised in that** the lubricant is a lubricant oil containing an aromatic compound and the ratio of carbon forming the aromatic cycle is at least 5 wt% of the total amount of carbon in the lubricant oil.

2. A coated member according to claim 1, wherein the lubricant oil is present as a strong oil film on the surface of the hard coating.

3. A coated member according to claim 2, wherein the coefficient of friction of the coated member having a strong oil film is less than the coefficient of friction of the same coated member not having the strong oil film.

4. A coated member according to claim 1, wherein said lubricant is selected from engine oil, light oil, gasoline, gear oil, turbine oil, spindle oil, machine oil, mobile oil and aircraft lubricant oil.

5. A coated member according to claim 1, wherein said hard coating has a first peak in a wave number range from 500 to 1000 cm$^{-1}$ in a Raman spectrum obtained by Raman scattered spectroscopy using an argon ion laser having a wavelength of 514.5 nm,
wherein an intensity ratio (I 600/I 1340) between a first peak intensity (I 600) of said first peak existing in a wave number range of 500 to 1000cm$^{-1}$ and a second peak intensity (I 1340) of a second peak existing around a wave number of 1340cm$^{-1}$ is at least 0.02 and at most 2.5, and / or an intensity ratio (S600 / S1340) of a first peak integration intensity (S600) existing in said wave number range of 500 to 1000cm$^{-1}$ and a second peak integration intensity (S1340) existing around a wave number of 1340cm$^{-1}$ is preferably at least 0.01 and at most 2.5.

6. A coated member according to claim 1, wherein said hard coating exhibits a peak around a wave number of 1560cm$^{-1}$ in a wave number range of 1560cm$^{-1}$ to 1580cm$^{-1}$ in a Raman spectrum obtained by Raman scattered spectroscopy using an argon ion laser having a wavelength of 514.5 nm,
wherein said hard coating exhibits a ratio (I 1340/I 1560) of at least 0.1 and at most 1.2 between a first peak intensity of a first peak around a wave number of 1560cm$^{-1}$ and a second peak intensity (I 1340) of a second peak around a wave number of 1340cm$^{-1}$ in a Raman spectrum obtained by Raman scattering spectroscopy using an argon ion laser having a wavelength of 514.5 nm, or exhibits a ratio (S1340 / S1560) of at least 0.3 and at most 3 between a first peak integration intensity (S1560) around a wave number of 1560cm$^{-1}$ and second peak integration intensity (S1340) around a wave number of 1340cm$^{-1}$ in a Raman spectrum obtained by Raman scattering spectroscopy using an argon ion laser having a wavelength of 514.5 nm.

7. A coated member according to claim 1, wherein said content of said hydrogen in said hard coating is not greater than 1 atomic %.

8. A coated member according to claim 1, wherein said hard coating has a coating density of 2.6 to 3.6 g/cm$^3$.

9. A coated member according to claim 1, wherein said carbon of said hard coating includes a carbon component having sp$^2$ bonding in an amount of 1 to 40 at.% in said hard coating.

10. A coated member according to claim 1, wherein said hard coating has a thickness of from 0.05 $\mu$m to 100 $\mu$m.

11. A coated member according to claim 1, wherein the intermediate layer between said substrate and said hard coating is formed of at least one material selected from elements of the IVa, Va and VIa groups of the periodic table, Al and Si as well as a carbide, a nitride and a nitrided carbide thereof.

12. A coated member according to claim 11, wherein the hard coating has a thickness of from 0.01 to 1 $\mu$m.

13. A coated member according to claim 1, wherein said substrate is at least one substrate material selected from ceramics, an iron based alloy, an aluminium alloy and an iron based sintered body.

**Patentansprüche**

1. Beschichtetes Element, das umfasst: ein Substrat,
eine harte Beschichtung, die direkt oder über eine Zwischenschicht auf wenigstens einem Teil des Substrats angeordnet ist, und
ein Schmiermittel, das in Kontakt mit der harten Beschichtung ist;
wobei die harte Beschichtung amorph ist und aus Kohlenstoff, unvermeidbaren Verunreinigungen und optional Wasserstoff in einer Menge von 5 Atom% oder weniger besteht;
die harte Beschichtung eine durchschnittliche Knoop-Härte (Hk) von 1.800 kg/mm$^2$ bis 8.000 kg/mm$^2$ hat, die mit dem Eindruckbruchverfahren unter Verwendung einer Knoop-Endrückvorrichtung aus Diamant, einer Belastung von 50g und einer Zeit des Ausübens der Belastung von 10 Sekunden gemessen wird, wobei der Durchschnittswert von zehn Messpunkten genommen wird; und
die harte Beschichtung eine durchschnittliche Mittellinien-Oberflächenrauhigkeit Ra von wenigstens 0,005 $\mu$m und höchstens 0,086 $\mu$m hat; und
das Ergebnis der Multiplikation (A) der durchschnittlichen Knoop-Härte mit der Oberflächenrauhigkeit höchstens 300 (Ra x Hk = A ≤ 300) beträgt,
**dadurch gekennzeichnet, dass** das Schmiermittel ein Schmieröl ist, das eine aromatische Verbindung enthält und der Anteil des Kohlenstoffes, der den aromatischen Zyklus ausbildet, wenigstens 5 Gew.-% der Gesamtmenge von Kohlenstoff in dem Schmieröl ausmacht.

2. Beschichtetes Element nach Anspruch 1, bei dem das Schmieröl als starker Ölfilm auf der Oberfläche der harten Beschichtung vorhanden ist.

3. Beschichtetes Element nach Anspruch 2, bei dem der Reibungskoeffizient des beschichteten Elementes, das einen starken Ölfilm hat, geringer ist als der Reibungskoeffizient desselben beschichteten Elementes, das nicht über den starken Ölfilm verfügt.

4. Beschichtetes Element nach Anspruch 1, wobei das Schmiermittel aus Motoröl, Leichtöl, Benzin, Getriebeöl, Turbinenöl, Spindelöl, Maschinenöl, Kraftfahrzeugöl und Flugzeugschmieröl ausgewählt wird.

5. Beschichtetes Element nach Anspruch 1, bei dem die harte Beschichtung eine erste Spitze in einem Wellenzahlbereich von 500 bis 1.000 cm$^{-1}$ in einem Raman-Spektrum hat, das durch Raman-Streuspektroskopie unter Verwendung eines Argon-Ionen-Lasers mit einer Wellenlänge von 514,5 nm erzeugt wird, ein Intensitätsverhältnis (I 600/I 1340) zwischen einer ersten Spitzenintensität (I 600) der ersten Spitze, die in einem Wellenzahlbereich von 500 bis 1000 cm$^{-1}$ vorhanden ist, und einer zweiten Spitzenintensität (I 1340) einer zweiten Spitze, die in einer Wellenzahl von 1.340 cm$^{-1}$ herum vorhanden ist, wenigstens 0,02 und höchsten 2,5 beträgt und/ oder ein Intensitätsverhältnis (S600 / S1.340) einer ersten Spitzen-Integrationsintensität (S600), die in dem Wellenzahlbereich von 500 bis 1.000 cm$^{-1}$ vorhanden ist, und einer zweiten Spitzen-Integrationsintensität (S1.340), die um eine Wellenzahl von 1.340 cm$^{-1}$ herum vorhanden ist, wenigstens 0,01 und höchsten 2,5 beträgt.

6. Beschichtetes Element nach Anspruch 1, bei dem die harte Beschichtung eine Spitze um eine Wellenzahl von 1.560 cm$^{-1}$ herum in einem Wellenzahlbereich von 1.560 cm$^{-1}$ bis 1580 cm$^{-1}$ in einem Raman-Spektrum aufweist, das durch Raman-Streuspektroskopie unter Verwendung eines Argon-Ionen-Lasers mit einer Wellenlänge von 514,5 nm erzeugt wird, die harte Beschichtung ein Verhältnis (I 1.340/I 1.560) von wenigstens 0,1 und höchstens 1,2 zwischen einer ersten Spitzenintensität einer ersten Spitze um eine Wellenzahl von 1.560 cm$^{-1}$ herum und einer zweiten Spitzenintensität (I 1.340) einer zweiten Spitze um eine Wellenzahl von 1.340 cm$^{-1}$ herum in einem Raman-Spektrum aufweist, das durch Raman-Streuspektroskopie unter Verwendung eines Argon-Ionen-Lasers mit einer Wellenlänge von 514,5 nm erzeugt wird, oder ein Verhältnis (S1.340 / S1.560) von wenigstens 0,3 und höchstens 3 zwischen einer ersten Spitzen-Integrationsintensität (S1.560) um eine Wellenzahl von 1.560 cm$^{-1}$ herum und einer zweiten Spitzen-Integrationsintensität (S1.340) um eine Wellenzahl von 1.340 cm$^{-1}$ herum in einem Raman-Spektrum aufweist, das durch Raman-Streuspektroskopie unter Verwertdung eines Argon-Ionen-Lasers mit einer Wellenlänge von 514,5 nm erzeugt wird.

7. Beschichtetes Element nach Anspruch 1, bei dem der Gehalt an Wasserstoff in der harten Beschichtung nicht mehr als 1 Atom-% beträgt.

8. Beschichtetes Element nach Anspruch 1, bei dem die harte Beschichtung eine Beschichtungsdichte von 2,6 bis 3,6 g/cm$^3$ hat.

9. Beschichtetes Element nach Anspruch 1, bei dem der Kohlenstoff der harten Beschichtung eine Kohlenstoffkomponente mit einer sp$^2$-Bindung in einer Menge von 1 bis 40 at.-% in der harten Beschichtung enthält.

10. Beschichtetes Element nach Anspruch 1, bei dem die Dicke der harten Beschichtung von 0,05 μm bis 100 μm reicht.

11. Beschichtetes Element nach Anspruch 1, bei dem die Zwischenschicht zwischen dem Substrat und der harten Schicht aus wenigstens einem Material besteht, das aus Elementen der Gruppen IVa, Va und VIa des Periodensystems, Al und Si sowie einem Karbid, einem Nitrid und einem nitrierten Karbid derselben besteht.

12. Beschichtetes Element nach Anspruch 1, bei dem die harte Beschichtung eine Dicke von 0,01 μm bis 1 μm hat.

13. Beschichtetes Element nach Anspruch 1, bei dem das Substrat wenigstens ein Substratmaterial ist, das aus Keramik, einer Legierung auf Eisenbasis, einer Aluminiumlegierung und einem Sinterkörper auf Eisenbasis ausgewählt wird.

**Revendications**

1. Elément revêtu comprenant :

   un substrat,
   un revêtement dur disposé directement ou via une couche intermédiaire sur au moins une partie du substrat, et
   un lubrifiant en contact avec ledit revêtement dur ;
   dans lequel :

   ledit revêtement dur est amorphe et est constitué de carbone, d'impuretés inévitables et facultativement d'hydrogène en une quantité de 5 % atomique ou inférieure ;
   ledit revêtement dur a une dureté Knoop (Hk) moyenne de 1 800 kg/mm$^2$ à 8 000 kg/mm$^2$, mesurée par le procédé de rupture à pénétration utilisant un pénétrateur Knoop en diamant, une charge de 50 g et une durée d'application de la charge de 10 secondes, la valeur moyenne de dix points de mesure étant prise ; et
   ledit revêtement dur a une rugosité de surface moyenne axiale Ra d'au moins 0,005 $\mu$m et d'au plus 0,086 $\mu$m ; et
   le produit de la multiplication (A) de ladite dureté Knoop moyenne par ladite rugosité de surface est d'au plus 300 (Ra x Hk = A $\leq$ 300),
   **caractérisé en ce que** le lubrifiant est une huile lubrifiante contenant un composé aromatique et le rapport de carbone formant le cycle aromatique est au moins 5 % en poids de la quantité totale de carbone dans l'huile lubrifiante.

2. Elément revêtu selon la revendication 1, dans lequel l'huile lubrifiante est présente sous forme d'un film d'huile résistant sur la surface du revêtement dur.

3. Elément revêtu selon la revendication 2, dans lequel le coefficient de frottement de l'élément revêtu ayant un film d'huile résistant est inférieur au coefficient de frottement du même élément revêtu n'ayant pas le film d'huile résistant.

4. Elément revêtu selon la revendication 1, dans lequel ledit lubrifiant est choisi parmi une huile de moteur, une huile fluide, de l'essence, une huile d'engrenage, une huile de turbine, une huile de broche, une huile de machine, une huile de grue et une huile lubrifiante pour avions.

5. Elément revêtu selon la revendication 1, dans lequel ledit revêtement dur présente un premier pic dans un intervalle de nombre d'onde de 500 à 1 000 cm$^{-1}$ dans un spectre Raman obtenu par une spectroscopie de diffusion Raman utilisant un laser aux ions argon présentant une longueur d'onde de 514,5 nm,
   dans lequel un rapport d'intensités (1 600/1 1340) entre une intensité de premier pic (I600) dudit premier pic existant dans un intervalle de nombre d'onde de 500 à 1 000 cm$^{-1}$ et une intensité de second pic (I 1340) d'un second pic existant aux environs d'un nombre d'onde de 1340 cm$^{-1}$ est d'au moins 0,02 et d'au plus 2,5, et/ou un rapport d'intensités (S600/S1340) d'une intensité d'intégration de premier pic (S600) existant dans ledit intervalle de nombre d'onde de 500 à 1 000 cm$^{-1}$ et d'une intensité d'intégration de second pic (S1340) existant aux environs d'un nombre d'onde de 1 340 cm$^{-1}$ est de préférence d'au moins 0,01 et d'au plus 2,5.

6. Elément revêtu selon la revendication 1, dans lequel ledit revêtement dur exhibe un pic aux environs d'un nombre d'onde de 1 560 cm$^{-1}$ dans un intervalle de nombre d'onde de 1 560 cm$^{-1}$ à 1 580 cm$^{-1}$ dans un spectre Raman obtenu par spectroscopie de diffusion Raman utilisant un laser aux ions argon ayant une longueur d'onde de 514,5 nm, dans lequel ledit revêtement dur exhibe un rapport (1 1340/1 1560) d'au moins 0,1 et d'au plus 1,2 entre une intensité de premier pic d'un premier pic autour d'un nombre d'onde de 1 560 cm$^{-1}$ et une intensité de second pic (I 1340) d'un second pic aux environs d'un nombre d'onde de 1 340 cm$^{-1}$ dans un spectre Raman obtenu par spectroscopie de diffusion Raman utilisant un laser aux ions argon ayant une longueur d'onde de 514,5 nm, ou exhibe un rapport (S1340/S1560) d'au moins 0,3 et d'au plus 3 entre une intensité d'intégration de premier pic (S1560) aux environs d'un nombre d'onde de 1 560 cm$^{-1}$ et d'une intensité d'intégration de second pic (S1340) aux environs d'un nombre d'onde de 1 340 cm$^{-1}$ dans un spectre Raman obtenu par spectroscopie de diffusion Raman utilisant un laser aux ions argon ayant une longueur d'onde de 514,5 nm.

7. Elément revêtu selon la revendication 1, dans lequel ladite teneur dudit hydrogène dans ledit revêtement dur est d'au plus 1 % atomique.

8. Elément revêtu selon la revendication 1, dans lequel ledit revêtement dur présente une densité de revêtement de 2,6 à 3,6 g/cm$^3$.

9. Elément revêtu selon la revendication 1, dans lequel ledit carbone dudit revêtement dur comprend un constituant de carbone présentant une liaison sp$^2$ dans une quantité de 1 à 40 % at. dans ledit revêtement dur.

10. Elément revêtu selon la revendication 1, dans lequel ledit revêtement dur a une épaisseur de 0,05 $\mu$m à 100 $\mu$m.

11. Elément revêtu selon la revendication 1, dans lequel la couche intermédiaire entre ledit substrat et ledit revêtement dur est constituée d'au moins un matériau choisi parmi des éléments des groupes IVa, Va et VIa de la Classification Périodique des Eléments, Al et Si ainsi qu'un carbure, un nitrure et un carbure nitruré de ceux-ci.

12. Elément revêtu selon la revendication 11, dans lequel le revêtement dur a une épaisseur de 0,01 à 1 $\mu$m.

13. Elément revêtu selon la revendication 1, dans lequel ledit substrat est au moins un matériau de substrat choisi parmi les céramiques, un alliage à base de fer, un alliage d'aluminium et un corps fritté à base de fer.

## FIG. 1

## FIG. 2

FIG. 3A

FIG. 3B

FIG. 4A

FIG. 4B

FIG. 5

FIG. 6

## FIG. 7

KNOOP HARDNESS

## FIG. 8

## FIG. 9

# FIG. 10

(HARDNESS)
×
(SURFACE
ROUGHNESS)

RATIO OF WEAR AMOUNT
OF COUNTERPART

♦ AMORPHOUS
CARBON

■ TiN

## FIG. 11

COEFFICIENT
OF FRICTION

KNOOP HARDNESS

FIG. 12

EP 2 000 560 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1052471 A
- JP 62120471 A
- JP 2029919 A
- JP 3037109 A
- JP 5151560 A
- JP 5174368 A
- JP 5325175 A
- JP 6111287 A
- JP 6267063 A
- JP 6349055 A
- JP 7085465 A
- JP 7192254 A
- JP 9091686 A
- JP 10091935 A
- JP 8329450 A
- JP 9153213 A
- JP 11025441 A
- JP 11086275 A
- JP 10049856 A
- JP 1226711 A
- JP 5117087 A
- JP 9040494 A
- JP 5117856 A
- JP 5296248 A
- JP 5186287 A
- EP 0905420 A2

**Non-patent literature cited in the description**

- *WEAR ZZZ,* 1998, 120-128